(19) 

**Europäisches Patentamt**
**European Patent Office**
**Office européen des brevets**

(11)　**EP 4 290 578 B1**

(12)　**EUROPEAN PATENT SPECIFICATION**

(45) Date of publication and mention
of the grant of the patent:
**20.08.2025　Bulletin 2025/34**

(21) Application number: **22775976.8**

(22) Date of filing: **16.03.2022**

(51) International Patent Classification (IPC):
**G01B 7/16** *(2006.01)*　　　**G09F 9/30** *(2006.01)*
**G06F 1/16** *(2006.01)*

(52) Cooperative Patent Classification (CPC):
**G01B 7/20; G06F 1/1624; G06F 1/1643;**
**G06F 1/1652; G06F 1/1677; G06F 1/1684;**
**G06F 3/041;** G09F 9/301; H10K 59/126

(86) International application number:
**PCT/KR2022/003679**

(87) International publication number:
**WO 2022/203274 (29.09.2022 Gazette 2022/39)**

(54) **DISPLAY INCLUDING DEFORMATION MEASUREMENT SENSOR, AND ELECTRONIC APPARATUS INCLUDING SAME**

ANZEIGE MIT VERFORMUNGSMESSSENSOR UND ELEKTRONISCHE VORRICHTUNG DAMIT

DISPOSITIF D'AFFICHAGE COMPRENANT UN CAPTEUR DE MESURE DE DÉFORMATION, ET APPAREIL ÉLECTRONIQUE LE COMPRENANT

(84) Designated Contracting States:
**AL AT BE BG CH CY CZ DE DK EE ES FI FR GB**
**GR HR HU IE IS IT LI LT LU LV MC MK MT NL NO**
**PL PT RO RS SE SI SK SM TR**

(30) Priority: **25.03.2021　KR 20210038953**

(43) Date of publication of application:
**13.12.2023　Bulletin 2023/50**

(73) Proprietor: **Samsung Electronics Co., Ltd.**
**Suwon-si, Gyeonggi-do 16677 (KR)**

(72) Inventors:
  • **CHOI, Sungdae**
    **Suwon-si, Gyeonggi-do 16677 (KR)**
  • **SHIN, Sungyoung**
    **Suwon-si, Gyeonggi-do 16677 (KR)**
  • **KIM, Minuk**
    **Suwon-si, Gyeonggi-do 16677 (KR)**

  • **SHIN, Hyunchang**
    **Suwon-si, Gyeonggi-do 16677 (KR)**
  • **KIM, Kyungtae**
    **Suwon-si, Gyeonggi-do 16677 (KR)**
  • **KIM, Kwangtai**
    **Suwon-si, Gyeonggi-do 16677 (KR)**
  • **YEOM, Donghyun**
    **Suwon-si, Gyeonggi-do 16677 (KR)**

(74) Representative: **HGF**
    **HGF Limited**
    **1 City Walk**
    **Leeds LS11 9DX (GB)**

(56) References cited:
    WO-A1-2019/041830　　KR-A- 20180 040 181
    KR-A- 20190 062 855　　KR-A- 20190 083 634
    KR-A- 20200 031 082　　KR-A- 20200 094 896
    US-A1- 2017 123 558

**Description**

[Technical Field]

Embodiments disclosed in the disclosure relate to a display including a strain gauge sensor, and an electronic device including the same.

[Background Art]

An electronic device may include a flexible display. For example, a flexible display may be disposed in an electronic device in a form, in which at least one area thereof may be curved, foldable, or rollable. A display area that is visually exposed to an outer surface of the electronic device may be expanded or contracted. State of the art electronic devices are known from WO 2019/041830 A1 and US 2017/123558 A1, which disclose flexible displays comprising sensors to identify the location where the flexible display is bent.

[Disclosure]

[Technical Problem]

The electronic device may include a strain gauge sensor for detecting a strain of the flexible display. In recent years, a strain gauge sensor having an enhanced sensitivity, by which a strain of the flexible display may be measured very precisely while a mounting space is minimized, have been required.

Various embodiments of the disclosure provide a display including a strain gauge sensor having an improved sensitivity, by which an expansion area of a display may be precisely measured, and an electronic device including the same.

[Technical Solution]

A display according to an embodiment disclosed in the disclosure may include a first area that is an active area, at least one second area disposed in parallel to the first area and being expandable from the first area, a first strain gauge sensor disposed in the second area, and formed in a zigzag form in a first direction that is an expansion direction of the second area, and a second strain gauge sensor disposed to be spaced apart from the first strain gauge sensor in the second area, and formed in a zigzag form in the first direction, the first strain gauge sensor may include a plurality of first resistance areas, lengths of which become gradually smaller as they go from one side to an opposite side of the second area along a second direction that is different from the first direction, and a plurality of first connection areas connecting the plurality of first resistance areas, and the second strain gauge sensor may include a plurality of second resistance areas, lengths of which become gradually larger as they go from one side to an opposite side of the second area, and a plurality of second connection areas connecting the plurality of second resistance areas.

An electronic device according to an example disclosed in the disclosure may include a display including a first area exposed to a front surface of the electronic device and at least one second area disposed in parallel to the first area and exposed to the front surface of the electronic device, a first strain gauge sensor disposed in the second area, and a resistance value of which is changed in inverse proportion to an exposure extent of the second area, a second strain gauge sensor disposed to be spaced apart from the first strain gauge sensor in the second area, and a resistance value of which is changed in proportion to an exposure extent of the second area, and a sensor driver that senses changes in the resistance values of the first strain gauge sensor and the second strain gauge sensor to sense an exposure degree of the second area.

[ Advantageous Effects]

According to embodiments disclosed in the disclosure, the electronic device may precisely measure the expansion degree of the display by busing a change in the resistance of the at least one strain gauge sensor disposed in the display.

According to embodiments disclosed in the disclosure, because the strain gauge sensor is formed in a zigzag form in a large area of the display whereby a length thereof becomes larger, a sensitivity of the strain gauge sensor, which is proportional to the length may be enhanced.

According to embodiments disclosed in the disclosure, in the electronic device, the at least one strain gauge sensor is formed by using the conductive layer included in the display whereby a separate mounting space of the strain gauge sensor is not necessary.

According to embodiments disclosed in the disclosure, in the electronic device, the first to fourth strain gauge sensors are formed repeatedly at least once whereby the temperature components included in the first to fourth strain gauge sensors may be compensated for or offset. Accordingly, the resistance value of the strain gauge sensor may be prevented from being changed by a change in an external temperature.

In addition, various effects directly or indirectly recognized through the disclosure may be provided.

[ Description of Drawings]

FIG. 1 is a view illustrating a front surface when an electronic device is in first to third states according to various embodiments.

FIG. 2 is a view illustrating a rear surface when an electronic device is in first to third states according to various embodiments.

FIG. 3 is a view illustrating a strain gauge sensor of an electronic device according to various embodiments.

FIG. 4A is a view illustrating a first strain gauge sensor and a second strain gauge sensor of an electronic device according to an embodiment, and FIG. 4B is a view illustrating changes in resistance values of the first strain gauge sensor and the second strain gauge sensor illustrated in FIG. 4A.

FIG. 5A is a view illustrating a first strain gauge sensor and a second strain gauge sensor of an electronic device according to another embodiment, and FIG. 5B is a view illustrating changes in resistance values of the first strain gauge sensor and the second strain gauge sensor illustrated in FIG. 5A.

FIG. 6 is a view illustrating a half-bridge circuit that may be implemented through a first strain gauge sensor and a second strain gauge sensor of an electronic device according to various embodiments.

FIG. 7 is a view illustrating first to fourth strain gauge sensors of an electronic device according to various embodiments.

FIG. 8 is a view illustrating a full-bridge circuit that may be implemented through first to fourth strain gauge sensors of an electronic device according to various embodiments.

FIGS. 9A and 9B are views illustrating a disposition relationship of first to fourth strain gauge sensors of an electronic device according to various embodiments.

FIG. 10A is a plan view illustrating first and second areas of an electronic device according to various embodiments, FIG. 10B is a cross-sectional view illustrating the first area illustrated in FIG. 10A, and FIG. 10C is a cross-sectional view illustrating the second area illustrated in FIG. 10A.

FIG. 11A is a plan view illustrating first and second areas of an electronic device according to various embodiments, and FIG. 11B is a cross-sectional view illustrating the first area illustrated in FIG. 11A.

FIG. 12 is a block diagram illustrating an electronic device according to various embodiments.

FIG. 13 is a view illustrating an electronic device including a strain gauge sensor embedded in a via hole according to various embodiments.

FIG. 14 is a view illustrating degrees of slip for locations of a resistance area included in a strain gauge sensor according to various embodiments.

FIG. 15 is a view illustrating resistance values for locations of a strain gauge sensor according to various embodiments.

FIG. 16 is a view illustrating a strain gauge sensor applied to a window of an electronic device according to various embodiments.

FIG. 17 is a view illustrating a second area of a display according to various embodiments in detail.

FIG. 18 is a block diagram illustrating an electronic device including a display, in which a plurality of strain gauge sensors are disposed, according to various embodiments.

FIG. 19 is a block diagram illustrating a sensor driver illustrated in FIG. 18 in detail.

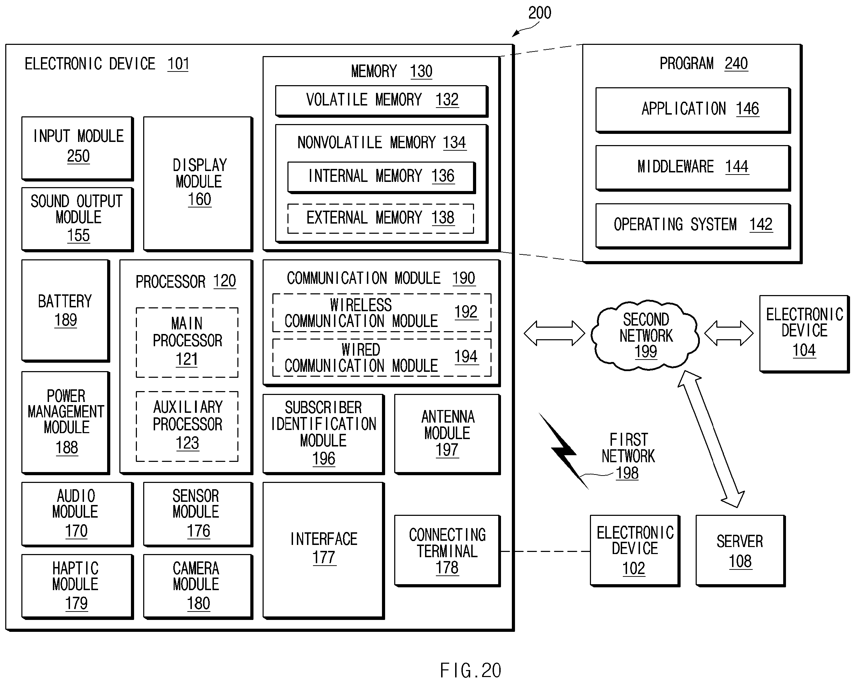

FIG. 20 is a block diagram illustrating an electronic device in a network environment according to various embodiments;

In relation to a description of the drawings, the same or similar reference numerals may be used for the same or similar components.

[ Mode for Invention]

Hereinafter, various embodiments of the disclosure will be described with reference to the accompanying drawings. However, it should be understood that the disclosure is not intended to limit specific embodied forms and includes various modifications, equivalents, and/or alternatives of the embodiments of the disclosure.

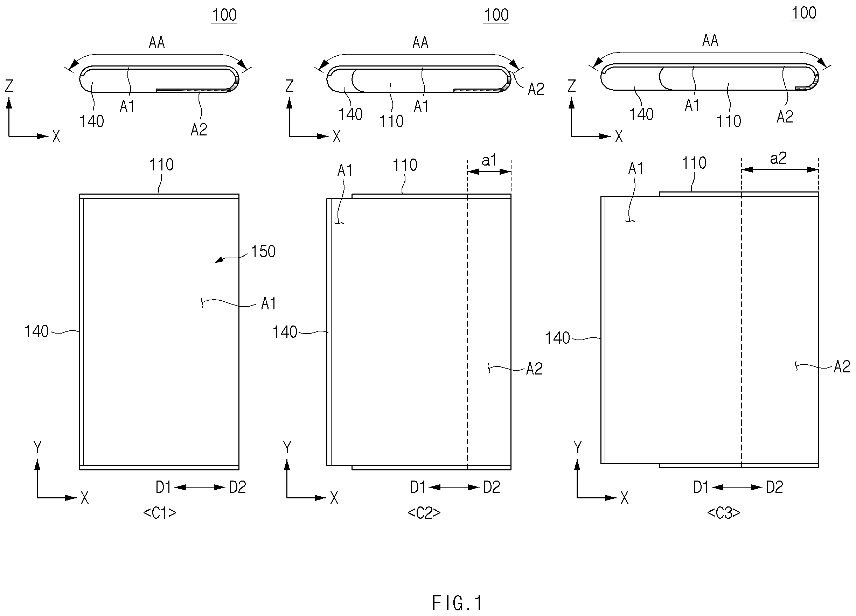

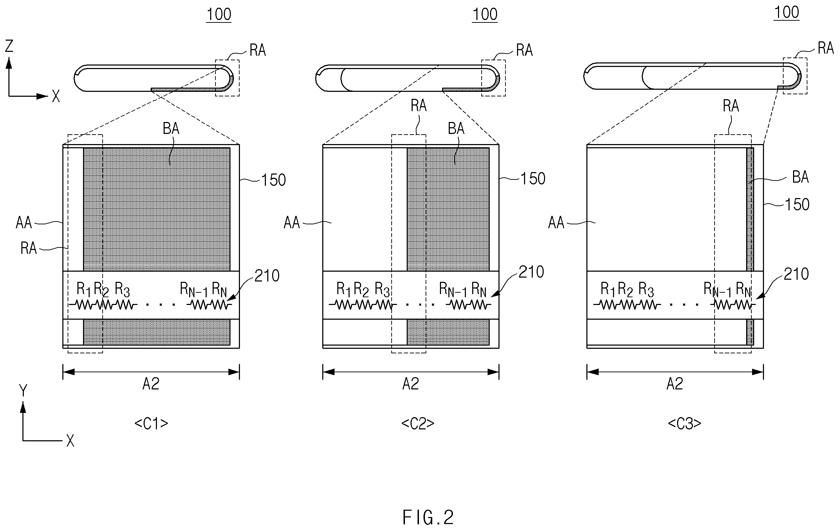

FIG. 1 is a view illustrating a front surface when an electronic device is in first to third states according to various embodiments, and FIG. 2 is a view illustrating a rear surface when the electronic device is in the first to third states according to various embodiments.

Referring to FIGS. 1 and 2, an electronic device 100 according to an embodiment may include a first housing **110,** a second housing 140, and a display 150.

The electronic device 100 according to an embodiment may be a slidable or rollable electronic device, and may include a first state C1 (e.g., a slide-in state or a contraction mode), a second state C2 (e.g., a first slide-out state or a first expansion mode), and a third state C3 (e.g., a second slide-out state or a second expansion mode). The first state C1, the second state C2, and the third state C3 may be determined according to a relative location of the second housing 140 to the first housing 110. The electronic device 100 may be strained between the first to third states C1, C2, and C3 through manipulation by a user or a mechanical operation.

In an embodiment, the first state C1 may mean a state, in which an extent (or size) of the display 150 that is visually exposed to a front surface of the electronic device 100 is reduced to a minimum size. The third state C3 may mean a state, in which the extent (or size) of the display 150 that is visually exposed to the front surface of the electronic device 100 is expanded to a maximum size. The second state C2 may mean a state, in which the extent (or size) of the display 150 that is visually exposed to the front surface of the electronic device 100 is expanded to be larger than the minimum size and smaller than the maximum size. Furthermore, in the first state C1, a portion (e.g., side parts 143 and 144 that face the y axis direction) of the second housing 140 is located inside the first housing 110 whereby the second housing 140 may be a slide-in state with respect to the first housing 110. In the second state C2 and the third state C3, the parts 143 and 144 of the second housing 140 may be drawn from the first housing 110 whereby the second housing 140 be in a slide-out state with respect to the first housing 110.

In an embodiment, the first housing 110 and the second housing 140 may be coupled to be slid with respect to each other. The second housing 140 may be coupled to one side of the first housing 110 to be slid. For example, the first housing 110 may be a fixed structure, and the second housing 140 may be a structure that may be moved with respect to the second housing 140. The second housing 140 may be coupled to one side (e.g., the -x axis direction) of the first housing 110 to be slid in opposite directions (e.g., the +x/-x direction) with respect to the first housing 110.

In an embodiment, the electronic device 100 may be strained to the first state C1, the second state C2, and the third state C3 as the second housing 140 is slid with respect to the first housing 110. For example, the electronic device 100 may be strained from the first state C1 to the second state C2 or the third state C3 as the second housing 140 is moved in a first direction D1 with respect to the first housing 110. In contrast, the electronic device 100 may be strained from any one of the second state C2 and the third state C3 to the first state C1 as the second housing 140 is moved in a second direction D2 with respect to the first housing 110.

In an embodiment, the size (or extent) of the area of the display 150, which is visually exposed to the front surface of the electronic device 100, may be changed in correspondence to sliding of the second housing 140. An exposure area of the display 150 may be expanded or contracted according to the sliding of the second housing 140 while being supported by at least one of the first housing 110 and the second housing 140. At least a portion of the display 150 may be flexible.

In an embodiment, the display 150 may include a first area (or a basic area) A1 and a second area (or an exposure area or an expansion area) A2 that extends from the first area A1. The first area A1 may be maintained in a state, in which it is visually exposed to the front surface of the electronic device 100. An extent of the second area A2, by which the second area A2 is visually exposed to the front surface of the electronic device 100 according to the state of the electronic device 100, may be changed. The second area A2 may be adjacent to one side (e.g., the +x axis direction) of the first area A1. For example, the first area A1 may mean a partial area of the display 150, which is visually exposed to the front surface of the electronic device 100 in the first to third states C1, C2, and C3. The second area A2 may mean an area that is located in an interior of the electronic device 100 in the first state C1 and, at least a portion of which is drawn from the interior of the electronic device 100 to be visually exposed to the front surface of the electronic device 100.

In an embodiment, the first state C1 may be a state, in which the first area A1 is located toward the front surface of the electronic device 100 and the second area A2 is located inside the first housing 110. An active area AA that may display an image in the first state C1 of the electronic device 100 may include the first area A1. Accordingly, the electronic device 100 may display an image through the first area A1 of the display 150 in the first state C1.

The second state C2 may be a state, in which a first expansion area a1 of the second area A2 is located toward the front surface of the electronic device 100 together with the first area A1. The active area AA that may display an image in the second state C1 of the electronic device 300 may include the first area A1, and the partial area a1 of the second area A2. Accordingly, the electronic device 100 may display an image through the first area A1 of the display 150, and the first expansion area a1 of the second area A2, in the second state C2.

The third state C3 may be a state, in which a second expansion area a2 of the second area A2 is located toward the front surface of the electronic device 100 together with the first area A1. An extent of the second expansion area a2 may be larger than an extent of the first expansion area a1. The active area AA that may display an image in the second state C1 of the electronic device 300 may include the first area A1, and the second expansion area a2 of the second area A2. Accordingly, the electronic device 100 may display an image through the first area A1 of the display 150, and the second expansion area a2 of the second area A2. In this way, in the electronic device 100, the second area A2 may be additionally visually exposed to the front surface of the electronic device 100 whereby an extent of the active area AA of the display 150 may be expanded.

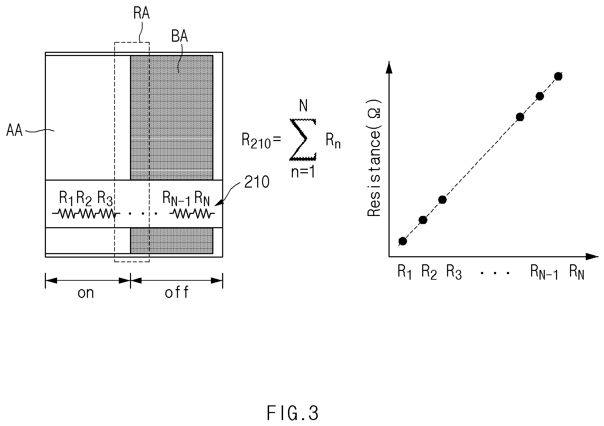

FIG. 2 is a view illustrating the rear surface when the electronic device is in first to third states according to various embodiments, and FIG. 3 is a view illustrating a strain gauge sensor of the electronic device according to various embodiments.

Referring to FIGS. 2 and 3, the electronic device 100 according to an embodiment may include at least one strain gauge sensor (strain gauge sensor) 210, a resistance value of which is different according to an expansion degree of the display 150. The strain gauge sensor 210 may be formed on a front surface (e.g., a surface which the +Z axis faces) of the second area A2. The strain gauge sensor 210 may include a plurality of resistance areas R1, R2, R3, · · · , and RN having different resistance values according to areas thereof with respect to a horizontal axis (e.g., the X axis) and/or a vertical axis (e.g., the Y axis). The strain gauge sensor 210 may have the plurality of resistance areas R1, R2, R3, ···, and RN that linearly increase or decrease in the second area A2. The strain gauge sensor 210 may have a total sum R210 of the resistance values of the plurality of resistance areas R1, R2, R3, ···, and RN that are connected in series to each other.

According to an expansion degree, a location of a rolling area RA of the second area A2 corresponding to a curved surface of the electronic device 100 may be changed. The expansion degree of the display may be sensed according to a resistance value of the strain gauge sensor 210 that corresponds to the rolling area RA to be physically strained.

According to an embodiment, according to the expansion degree of the display, which is sensed through the strain gauge sensor 210, at least a partial area of the second area A2, which is not used as the active area AA, may not be exposed. The second area A2 that is not exposed may not display an image to reduce driving power. In the first state C1, the rolling area RA may overlap, among the resistance areas included in the strain gauge sensor 210, a resistance area (e.g., R1 and R2), a resistance value is relatively small. Because the resistance area (e.g., R1 and R2) having a relatively small (or large) resistance value is strained, the first state C1, in which the second area A2 of the electronic device is not expanded, may be sensed through the strain gauge sensor 210. Accordingly, the first area A1 of the display 150 may be activated (on) to display an image, and a maximum area of the second area A2 may be deactivated (off) to a black area BA that displays a black color.

In the second state C2, the rolling area RA may overlap, among the resistance areas included in the strain gauge sensor 210, the resistance area, a resistance value of which is relatively intermediate. Because the resistance area having a relatively intermediate resistance value is strained, the second state C2, in which a portion of the second area A2 of the electronic device is expanded, may be sensed through the strain gauge sensor 210. Accordingly, the first area A1 and a partial area of the second area A2 of the display 150 may be activated to display an image, and the remaining areas of the second area A2 may be deactivated (off) to the black area BA that displays a black area.

In the third state C3, the rolling area RA may overlap, among the resistance areas included in the strain gauge sensor 210, the resistance area (e.g., RN-1 and RN) having a relatively large (or small) resistance value. Because the resistance area (e.g., RN-1 and RN) having a relatively large (small) resistance value is strained, the strain gauge sensor 210 may detect the third state C3, in which the second area A2 of the electronic device is expanded to a maximum area. Accordingly, the first area A1 and the second area A2 of the display 150 may be activated (on) to display an image.

According to various embodiments, the second area A2 that is not exposed may not display an image and thus may display a burn-in preventing image instead of displaying a black color. When the burn-in preventing image is displayed in the second area A2 that is not exposed, a driving frequency and/or a light emission frequency may be reduced for driving.

According to various embodiments, in the first state C1, the active area AA may include the first area A1, except for the second area A2, as illustrated in FIG. 1, and may include a portion of the second area A2 as well as the first area A1 as illustrated in FIG. 2. According to various embodiments, the first area A1 may not be included in the rolling area RA according to the shape of the housing (e.g.., the first housing 110 and the second housing 140 of FIG. 1).

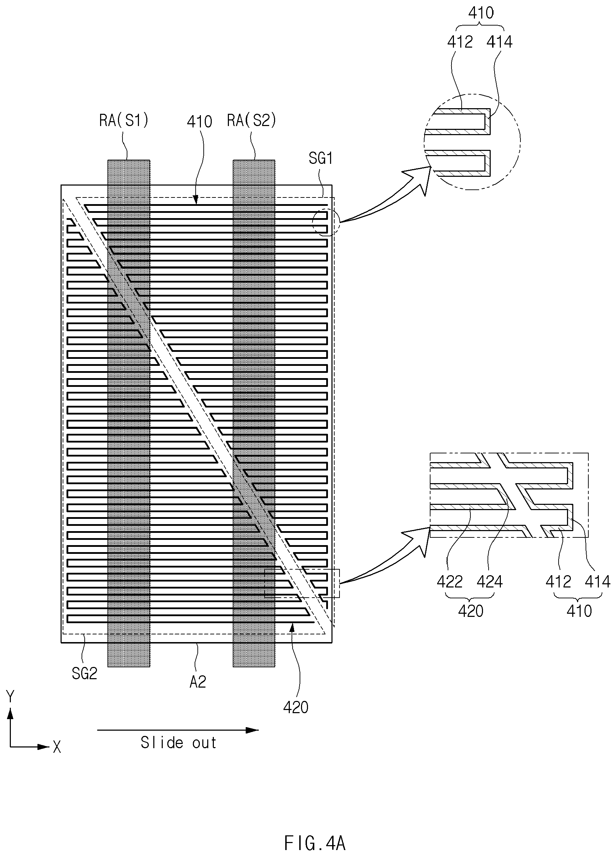

The electronic device according to various embodiments, as illustrated in FIGS. 4A to 5B, may include a first strain gauge sensor and a second strain gauge sensor formed in the display. Because the first strain gauge sensor and the second strain gauge sensor detect changes in the expansions and contracts in opposite directions, a sensing sensitivity of a strain of the display may be improved.

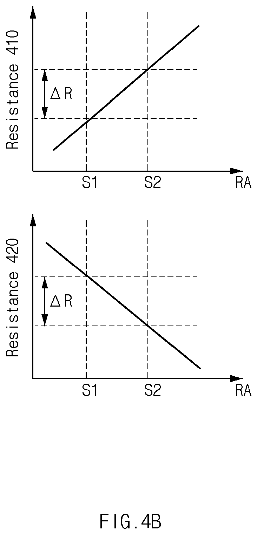

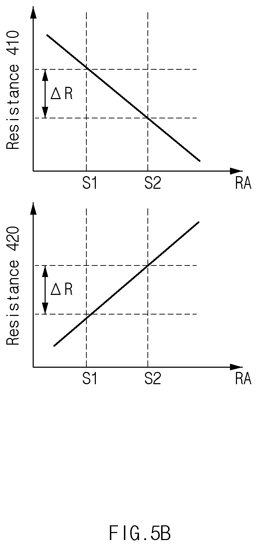

FIGS. 4A and 5B are plan views illustrating the second area, in which the first strain gauge sensor and the second strain gauge sensor included in the display according to various embodiments, and FIGS. 4B and 5B are views illustrating changes in resistance values of the first strain gauge sensor and the second strain gauge sensor according to a location of the rolling area of the display panel included in the electronic device according to various embodiments.

Referring to FIG. 4A, the second area A2 of the display panel of the electronic device according to an embodiment may include a first strain area SG1 and a second strain area SG2. The first strain area SG1 and the second strain area SG2 may have the same or similar areas.

The first strain area SG1 and the second strain area SG2 may have an imaginary right triangular shape. An inclined area of the first strain area SG1 and an inclined area of the second strain area SG2 may be disposed to be adjacent to each other. A first strain gauge sensor 410 may be disposed in the first strain area **SG1,** and a second strain gauge sensor 420 may be disposed in the second strain area SG2. Sensitivies of the first strain gauge sensor 410 and the second strain gauge sensor 420 may be the same. It becomes better as the sensitivities of the first strain gauge sensor 410 and the second strain gauge sensor 420 become higher to detect a change of a locational state of the rolling area RA.

The sensitivity of at least any one of the first strain gauge sensor 410 and the second strain gauge sensor 420 is as in Equation 1. In Equation 1, R may denote an electrical resistance, ε denotes a unit strain, ρ may denote a specific resistance, S may denote cross-sectional areas of the first strain gauge sensor 410 and the second strain gauge sensor 420, "1" may denote lengths of the first strain gauge sensor 410 and the second strain gauge sensor 420

[Equation 1]

$$\mathrm{Sensitivity} \cong \frac{\Delta\,{}^{R}\!/\!_{Ro}}{\Delta\,{}^{\varepsilon}\!/\!_{\varepsilon o}} = \frac{\rho}{S} \cdot \frac{l - lo}{\Delta\,{}^{\varepsilon}\!/\!_{\varepsilon o}}$$

In Equation 1, the sensitivities of the first strain gauge sensor 410 and the second strain gauge sensor 420 may be inversely proportional to the cross-sectional areas of the first strain gauge sensor 410 and the second strain gauge sensor 420. The sensitivities of the first strain gauge sensor 410 and the second strain gauge sensor 420 may be proportional to changes in the lengths of the first strain gauge sensor 410 and the second strain gauge sensor 420, respectively. Accordingly, at least any one of the first strain gauge sensor 410 and the second strain gauge sensor 420 may be formed of a conductive material in a zigzag form such that the cross-sectional area thereof is small and the length thereof is large to enhance sensitivity.

The first strain gauge sensor 410 may have a repeated pattern that reciprocates forwards and rearwards in the expansion direction (e.g., the +X axis direction) of the second area A2. The first strain gauge sensor 410 may have a zigzag form, a length of which becomes gradually smaller as it goes from one side (e.g., the +Y axis direction) to an opposite side (e.g., the -Y axis direction) of the second area A2. The first strain gauge sensor 410 may include a plurality of first resistance areas 412 and a plurality of first connection areas 414.

Lengths of the plurality of first resistance areas 412 may be formed along the expansion direction (e.g., the +X axis direction) of the second area A2. The lengths of the plurality of first resistance areas 412 may become gradually smaller as they go from one side of the second area A2 to an opposite side of the second area A2. The plurality of first resistance areas 412 may be disposed to be spaced apart from the adjacent first resistance areas 412 at uniform or irregular intervals. Because spacing directions and sliding directions of the plurality of first resistance areas 412 are perpendicular to each other, the plurality of first resistance areas 412 may not be disposed at a specific interval.

The plurality of first connection areas 414 may be disposed between the adjacent first resistance areas 412 to connect the adjacent first resistance areas 412. The plurality of first connection areas 414 may have a similar or the same length. Some of the plurality of first connection areas 414 may be disposed to be close to the second strain gauge sensor 420, and the remaining ones of the plurality of first connection areas 414 may be disposed to be far away from the second strain gauge sensor 420. The first connection areas 414 that are disposed to be close to the second strain gauge sensor 420 and the first connection areas 414 that are disposed to be far away from the second strain gauge sensor 420 may be alternately disposed.

The second strain gauge sensor 420 may be formed in a repeated pattern that reciprocates forwards and rearwards in the expansion direction (e.g., the +X axis direction) of the second area A2. The second strain gauge sensor 420 may have a zigzag form, a length of which becomes gradually larger as it goes from one side (e.g., the +Y axis direction) to an opposite side (e.g., the -Y axis direction) of the second area. The second strain gauge sensor 420 may include a plurality of second resistance areas 422 and a plurality of second connection areas 424.

Lengths of the plurality of second resistance areas 422 may be formed along the expansion direction (e.g., the +X axis direction) of the second area A2. The lengths of the plurality of second resistance areas 422 may become gradually larger as they go from one side of the second area A2 to an opposite direction of the second area A2. The plurality of second resistance areas 422 may be disposed to be spaced apart from the adjacent second resistance areas 422 at uniform or irregular intervals. Because spacing directions and sliding directions of the plurality of second resistance areas 422 are perpendicular to each other, the plurality of second resistance areas 422 may not be disposed at a specific interval.

The plurality of second connection areas 424 may be disposed between the adjacent second resistance areas 422 to connect the adjacent second resistance areas 422. The plurality of second connection areas 424 may have a similar or the same length. Some of the plurality of second connection areas 424 may be disposed to be closer to the first strain gauge sensor 410, and the remaining ones of the plurality of second connection areas 424 may be disposed to be far away from the first strain gauge sensor 410. The second connection areas 424 that are disposed to be close to the first strain gauge sensor 410 and the second connection areas 424 that are disposed to be far away from the first strain gauge sensor 410 may be alternately disposed.

According to an embodiment, the first strain gauge sensor 410 and the second strain gauge sensor 420 may be formed on the same material as that of any one of the plurality of conductive layers disposed in at least any one of the first area A1 and the second area A2 of the display on the same layer as that thereof. Then, the first strain gauge sensor 410 and the second strain gauge sensor 420 may be formed not to influence a path of the light that is generated in the light emitting element of the display and is output to an outside.

According to various embodiments, the first strain gauge sensor 410 and the second strain gauge sensor 420 may be expanded or contracted as the second area A2 is expanded whereby a resistance value thereof may be changed. The resistance value of the first strain gauge sensor 410 may be changed to be proportional to the exposure extent of the second area A2, which is exposed to an outside. The resistance value of the second strain gauge sensor 420 may be changed to be inversely proportional to the exposure extent of the second area A2, which is exposed to an outside. As illustrated in FIGS. 4A and 4B, the resistance value of the first strain gauge sensor 410 may gradually increase as it is slid out, and the resistance value of the second strain gauge sensor 420 may gradually decrease as it is slid out.

For example, the rolling area RA may be strained from a first rolling state S1 to a second rolling state S2 according to the sliding out of the second housing (e.g., the second housing 140 of FIGS. 1 and 2). When the rolling area RA is strained from the first rolling state S1 to the second rolling state S2, a change in the length of the first resistance area 414 of the first strain gauge sensor 410 may increase. Due to an increase of the change in the length of the first resistance area 414, the resistance value of the first strain gauge sensor 410, as illustrated in FIG. 4B, may increase by a change $\Delta R$ from an initial resistance value Ro. When the rolling area RA is strained from the first rolling state S1 to the second rolling state S2, the change in the length of the second resistance area 424 of the second strain gauge sensor 420 may decrease. Due to a decrease of the change in the length of the second resistance area 424, the resistance value of the second strain gauge sensor 420, as illustrated in FIG. 4B, may decrease by the change $\Delta R$ from the initial resistance value Ro.

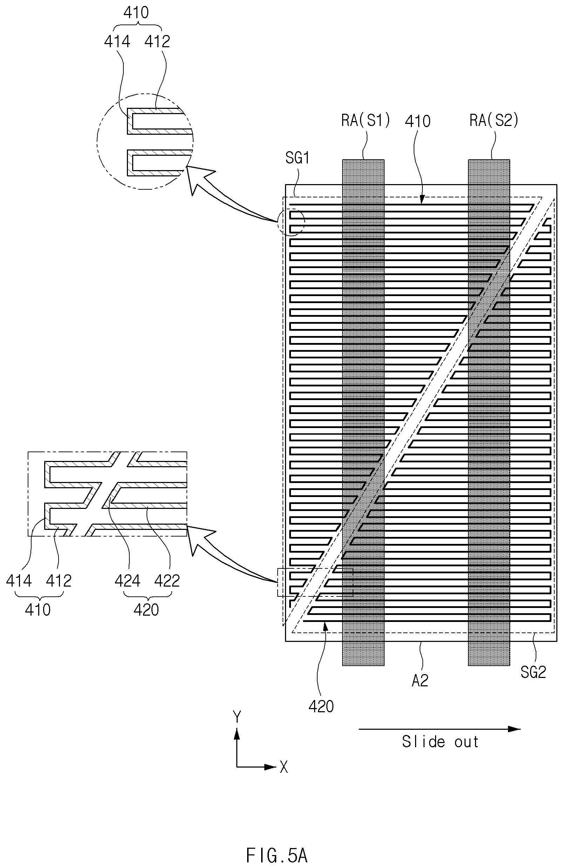

According to various embodiments, locations of the first strain gauge sensor 410 and the second strain gauge sensor 420 may be variously changed. As illustrated in FIGS. 5A and 5B, the resistance value of the first strain gauge sensor 410 may gradually decrease as it is slid out, and the resistance value of the second strain gauge sensor 420 may gradually increase as it is slid out. For example, according to the sliding out of the second housing, the rolling area RA may be strained from the first rolling state S1 to the second rolling state S2. When the rolling area RA is strained from the first rolling state S1 to the second rolling state S2, the change in the length of the first resistance area 414 of the first strain gauge sensor 410 may decrease. Due to a decrease of the change in the length of the first resistance area 414, the resistance value of the first strain gauge sensor 410, as illustrated in FIG. 5B, may decrease by the change $\Delta R$ from the initial resistance value Ro. When the rolling area RA is strained from the first rolling state S1 to the second rolling state S2, the change in the length of the second resistance area 424 of the second strain gauge sensor 420 may increase. Due to an increase of the change in the length of the second resistance area 424, the resistance value of the second strain gauge sensor 420, as illustrated in FIG. 5B, may increase by the change $\Delta R$ from the initial resistance value Ro.

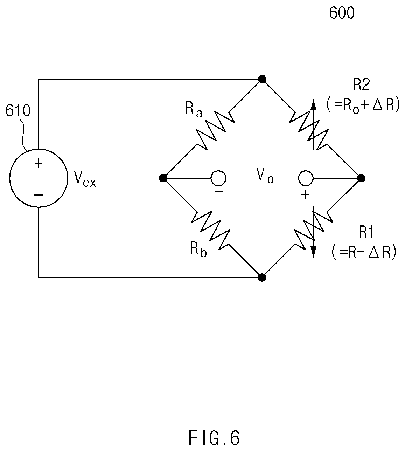

FIG. 6 is a view illustrating a Wheatstone bridge circuit 600 that may be implemented through the first strain gauge sensor and the second strain gauge sensor of the display according to various embodiments.

Referring to FIG. 6, a first strain gauge sensor R1 (e.g., the first strain gauge sensor 410 of FIG. 4) and second strain gauge sensors R2 (e.g., the second strain gauge sensor 420 of FIG. 4) may correspond to resistances, values of which are changed according to the expansion and contraction of the second area A2. Resistances of the first strain gauge sensor R1 and the second strain gauge sensor R2 may be changed according to an expansion degree of the second area A2. The Wheatstone bridge circuit 600 may be constituted by using the first strain gauge sensor R1 and the second strain gauge sensor R2. An output voltage Vo that is proportional to the expansion degree of the second area A2 may be obtained through the Wheatstone bridge circuit 600.

The Wheatstone bridge circuit 600 may use a half-bridge circuit for detecting changes of the first strain gauge sensor R1 and the second strain gauge sensor R2, in which the expansion and the contraction occur in opposite ways. The half-bridge circuit may include the first strain gauge sensor R1, the second strain gauge sensor R2, a first reference resistor Ra, and a second reference resistor Rb. The output voltage Vo of the half-bridge circuit is as in Equation 2.

[Equation 2]

$$\text{Vo} = \left(\frac{R1}{R1 + R2} - \frac{Rb}{Ra + Rb}\right) \cdot \text{Vex}$$

In the half-bridge circuit, initial resistance values Ro of the first strain gauge sensor R1, the second strain gauge sensor R2, the first reference resistor Ra, and the second reference resistor Rb may be the same. The first strain gauge sensor R1 may decrease by a change $\Delta R$ of the second strain gauge sensor R2, and the second strain gauge sensor R2 may increase by a change $\Delta R$ of the first strain gauge sensor R1. The changes $\Delta R$ of the first strain gauge sensor R1 and the second strain gauge sensor R2 may be very small as compared with the initial resistance value Ro. When the condition is satisfied, the output voltage Vo of the half-bridge circuit may be proximate as in Equation 3.

[Equation 3]

$$\text{Vo} = \frac{\Delta R}{R} \cdot \text{Vex}$$

Equation 3 may be replaced by Equation 4 by using a gauge coefficient k and a strain ε by a mechanical strain. In Equation 4, the gauge coefficient k may be defined by a change in resistance, which is exerted by the gauge for a unit strain, and may be provided by a manufacturer of the electronic device. In Equation 4, a precise strain of the second area A2 may be measured through the output voltage Vo of the half-bridge circuit.

[Equation 4]

$$\frac{\Delta R}{R} = k \cdot \varepsilon \, Vo = k \cdot \varepsilon \cdot Vex$$

In this way, an electric voltage Vex is distributed to the resistors by suppling the electric voltage Vex of a power supply 610, a magnitude of the voltage Vo output from the half-bridge circuit may be changed according to the changes ΔR of the resistances of the first strain gauge sensor R1 and the second strain gauge sensor R2. An expansion degree of the second area A2 may be detected by the output voltage Vo of the half-bridge circuit.

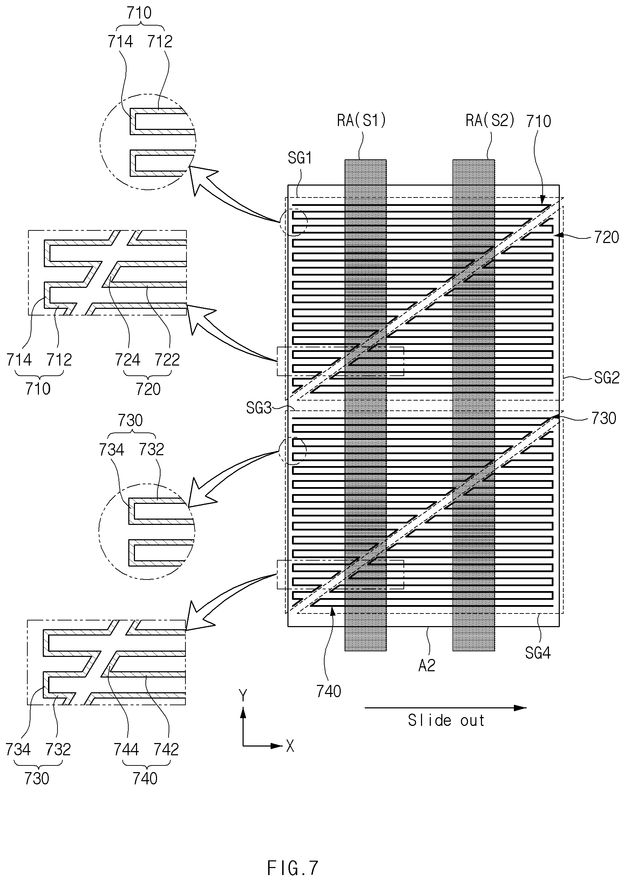

FIG. 7 is a plan view illustrating the second area, in which the first to fourth strain gauge sensors included in the display are disposed, according to various embodiments.

Referring to FIG. 7, the second area A2 of the display panel of the electronic device according to an embodiment may include the first strain area SG1, the second strain area SG2, a third strain area SG3, and a fourth strain area SG4.

The first strain area SG1, the second strain area SG2, the third strain area SG3, and the fourth strain area SG4 may have an imaginary right triangular shape. An inclined area of the first strain area SG1 and an inclined area of the second strain area SG2 may be disposed to be adjacent to each other, and an inclined area of the third strain area SG3 and an inclined area of the fourth strain area SG4 may be disposed to be adjacent to each other. A first strain gauge sensor 710 may be disposed in the first strain area SG1, a second strain gauge sensor 720 may be disposed in the second strain area SG2, a third strain gauge sensor 730 may be disposed in the third strain area SG3, and a fourth strain gauge sensor 740 may be disposed in the fourth strain area SG4.

At least any one of the first strain gauge sensor 710, the second strain gauge sensor 720, the third strain gauge sensor 730, and the fourth strain gauge sensor 740 may be formed of a conductive material in a zigzag form having a small cross-sectional shape and a large length. Accordingly, the sensitivities of the first strain gauge sensor 710, the second strain gauge sensor 720, the third strain gauge sensor 730, and the fourth strain gauge sensor 740 for detecting a change in a locational state of the rolling area RA may be enhanced.

The first strain gauge sensor 710 and the third strain gauge sensor 730 may have the same shape. The third strain gauge sensor 730 may be disposed between the second strain gauge sensor 720 and the fourth strain gauge sensor 740. The first strain gauge sensor 710 and the third strain gauge sensor 730 may have a zigzag form, a length of which becomes gradually smaller as it goes from one side (e.g., the +Y axis direction) to an opposite side (e.g., the -Y axis direction) of the second area A2.

The second strain gauge sensor 720 and the fourth strain gauge sensor 740 may have the same shape. The second strain gauge sensor 720 may be disposed between the first strain gauge sensor 710 and the third strain gauge sensor 730. The second strain gauge sensor 720 and the fourth strain gauge sensor 740 may have a zigzag form, a length of which becomes gradually larger as it goes from one side (e.g., the Y axis direction) to an opposite direction (e.g., the -Y axis direction) of the second area.

The first strain gauge sensor 710 may include a plurality of first resistance areas 712 and a plurality of first connection areas 714. The third strain gauge sensor 730 may include a plurality of third resistance areas 732 and a plurality of third connection areas 734. The second strain gauge sensor 720 may include a plurality of second resistance areas 722 and a plurality of second connection areas 724, and the fourth strain gauge sensor 740 may include a plurality of fourth resistance areas 742 and a plurality of fourth connection areas 744. Hereinafter, for convenience of description of the first to fourth strain gauge sensor, the first resistance area 712, the second resistance area 722, the first connection area 714, and the second connection area 724 will be mainly described, and this also may be applied to the third resistance area 732, the third resistance area 7832, the fourth connection area 744, and the fourth connection area 744. For example, the description of the first resistance area 712 and the first connection area 714 may be applied to the description of the third resistance area 732 and the third connection area 734, and the description of the second resistance area 722 and the second connection area 724 may be applied to the description of the fourth resistance area 742 and the fourth connection area 744.

Lengths of the plurality of first resistance areas 712 may be formed along the expansion direction (e.g., the +X axis direction) of the second area A2. The lengths of the plurality of first resistance areas 712 may become gradually smaller as they go from one side of the second area A2 to an opposite side of the second area A2. The plurality of first resistance areas 712 may be disposed to be spaced apart from the adjacent first resistance areas 712 at uniform or irregular intervals. Because a spacing direction and a sliding direction of the plurality of first resistance areas 712 are perpendicular to each other, the plurality of first resistance areas 712 may not be disposed at a specific interval.

The plurality of first connection areas 714 may be disposed between the adjacent first resistance areas 712 to connect the adjacent first resistance areas 712. The plurality of second connection areas 714 may have a similar or the same length. Some of the plurality of second connection areas 714 may be disposed to be close to the second strain gauge sensor 720, and the remaining ones of the plurality of second connection areas 714 may be disposed to be far away from the second strain gauge sensor 720. The first connection areas 714 that are disposed to be close to the second strain gauge sensor 720 and the first connection areas 714 that are disposed to be far away from the second strain gauge sensor 420 may be alternately disposed.

Lengths of the plurality of second resistance areas 722 may be formed along the expansion direction (e.g., the +X direction) of the second area A2. The lengths of the plurality of second resistance areas 722 may become gradually larger as they go from one side of the second area A2 to an opposite side to the second area A2. The plurality of second resistance areas 422 may be disposed to be spaced apart the adjacent second resistance areas 722 at uniform or irregular intervals. Because a spacing direction and a sliding direction of the plurality of second resistance areas 722 are perpendicular to each other, the plurality of second resistance areas 722 may not be disposed at a specific interval.

The plurality of second connection areas 724 may be disposed between the adjacent second resistance areas 722 to connect the adjacent second resistance areas 722. The plurality of second connection areas 724 may have a similar or the same length. Some of the plurality of second connection areas 724 may be disposed to be close to the first strain gauge sensor 710, and the remaining ones of the plurality of second connection areas 724 may be disposed to be far away from the first strain gauge sensor 710. The second connection areas 724 that are disposed to be close to the first strain gauge sensor 710 and the second connection areas 724 that are disposed to be far away from the first strain gauge sensor 710 may be alternately disposed.

According to an embodiment, the first strain gauge sensor 710 and the second strain gauge sensor 720 may be formed of the same material on the same layer as any one of the plurality of conductive layers disposed in at least any one of the first area A1 and the second area A2 of the display. Then, the first strain gauge sensor 710 and the second strain gauge sensor 720 may be formed not to influence a path of the light that is output to an outside through the display.

According to various embodiments, the first to fourth strain gauge sensors 710 to 740 may be expanded or contracted as the second area A2 is expanded whereby the resistance values thereof may be changed. For example, according to the sliding out of the second housing (e.g., the second housing 140 of FIGS. 1 and 2), the rolling area RA may be strained from the first rolling state S1 to the second rolling state S2. When the rolling area RA is strained from the first rolling state S1 to the second rolling state S2, the changes in the lengths of the first resistance area 714 of the first strain gauge sensor 710 and the third resistance area 734 of the third strain gauge sensor 730 may decrease. Due to a decrease in the changes in the lengths of the first resistance area 714 and the third resistance area 734, the resistance values of the first strain gauge sensor 710 and the third strain gauge sensor 730 may decrease by the change $\Delta R$ from the initial resistance value Ro. When the rolling area RA is strained from the first rolling state S1 to the second rolling state S2, the changes in the lengths of the second resistance area 724 of the second strain gauge sensor 720 and the fourth resistance area 744 of the fourth strain gauge sensor 740 may increase. Due to an increase in the changes in the lengths of the second resistance area 724 and the fourth resistance area 744, the resistance values of the second strain gauge sensor 720 and the fourth strain gauge sensor 740 may increase by the change $\Delta R$ from the initial resistance value Ro.

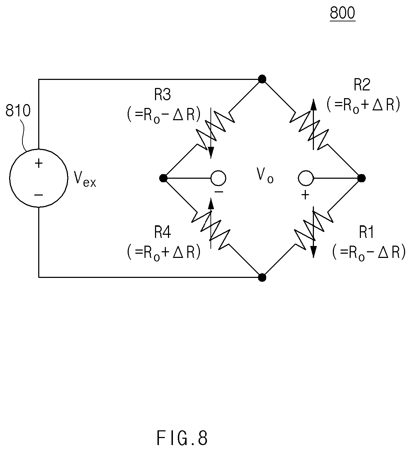

FIG. 8 is a view illustrating a full-bridge circuit that may be implemented through the first to fourth strain gauge sensors of the electronic device according to various embodiments.

Referring to FIG. 8, the first strain gauge sensor R1 (e.g., the first strain gauge sensor 710 of FIG. 1), the second strain gauge sensor R2 (e.g., the second strain gauge sensor 720 of FIG. 1), the third strain gauge sensor R3 (e.g., the third strain gauge sensor 730 of FIG. 1), and the fourth strain gauge sensor R4 (e.g., the fourth strain gauge sensor 740 of FIG. 1) may correspond to a resistance that is changed according to an expansion and a contraction of the second area A2. The resistances of the first strain gauge sensor R1, the second strain gauge sensor R2, the third strain gauge sensor R3, and the fourth strain gauge sensor R4 may be changed according to the expansion degree of the second area A2.

A Wheatstone bridge circuit 800 may be constituted by using the first strain gauge sensor R1, the second strain gauge sensor R2, the third strain gauge sensor R3, and the fourth strain gauge sensor R4. The output voltage Vo that is proportional to the expansion degree of the second area A2 may be obtained through the Wheatstone bridge circuit 800.

The Wheatstone bridge circuit 800 may use a full-bridge circuit for detecting changes in the first strain gauge sensor R1 and the second strain gauge sensor R2, in which the expansion and the contraction occur in opposite ways, and changes in the third strain gauge sensor R3 and the fourth strain gauge sensor R4, in which the expansion and the contraction occur in opposite ways. The output voltage Vo of the full-bridge circuit is as in Equation 5.

[Equation 5]

$$Vo = \left(\frac{R1}{R1 + R2} - \frac{R4}{R3 + R4}\right) \cdot Vex$$

In the full-bridge circuit, the initial resistance values Ro of the first strain gauge sensor R1, the second strain gauge sensor R2, the third strain gauge sensor R3, the fourth strain gauge sensor R4 may be the same. Changes $\Delta R$ in the resistances of the first strain gauge sensor R1, the second strain gauge sensor R2, the third strain gauge sensor R3, the fourth strain gauge sensor R4 may be the same. The first strain gauge sensor R1 and the third strain gauge sensor R3 may decrease by the change $\Delta R$ in the resistance of the same magnitude, and the second strain gauge sensor R2 and the fourth strain gauge sensor R4 may increase by the change $\Delta R$ in the resistance of the same magnitude. The changes $\Delta R$ in the first strain gauge sensor R1, the second strain gauge sensor R2, the third strain gauge sensor R3, and the fourth strain gauge sensor R4 may be very small as compared with the initial resistance value Ro. When the condition is satisfied, the output voltage Vo of the full-bridge circuit may be proximate as in Equation 3 $\left(Vo = \frac{\Delta R}{R} \cdot Vex.\right)$ as in the half-bridge circuit illustrated in FIG. 6. Because Equation 2 may be replaced by Equation 4 $\left(Vo = k \cdot \varepsilon \cdot Vex\right)$ like in the half-bridge circuit 600 illustrated in FIG. 6, a precise strain of the second area may be measured through the output voltage Vo of the full-bridge circuit 800.

In this way, when the electric voltage Vex is distributed to the resistances by supplying the electric voltage Vex of the power supply, a magnitude of the voltage Vo that is output from the full-bridge circuit according to the changes $\Delta R$ of the resistances of the first strain gauge sensor R1, the second strain gauge sensor R2, the third strain gauge sensor R3, and the fourth strain gauge sensor R4 may be changed. The expansion degree of the second area A2 may be detected by the output voltage Vo of the full-bridge circuit.

According to various embodiments, the first strain gauge sensor R1 and the second strain gauge sensor R2 illustrated in FIG. 6, and the first strain gauge sensor R1, the second strain gauge sensor R2, the third strain gauge sensor R3, and the fourth strain gauge sensor R4 illustrated in FIG. 8 may be changed to specific magnitudes by an external temperature, as in Equations 6 and 7. In Equations 6 and 7, $\varepsilon m$ may be a mechanical strain of the second area, and $\varepsilon t$ may be a strain due to thermal expansion.

[Equation 6]

$$\frac{\Delta R}{R} = k \cdot (\varepsilon m + \varepsilon t)$$

[Equation 7]

$$-\frac{\Delta R}{R} = k \cdot (-\varepsilon m + \varepsilon t)$$

By substituting Equations 6 and 7 with Equation 2, the factors $\varepsilon t$ due to the temperature change are offset, and thus it may be seen that temperature may be compensated for in the Wheatstone bridge circuit (e.g., the Wheatstone bridge circuit 600 of FIG. 6 and the Wheatstone bridge circuit 800 of FIG. 8).

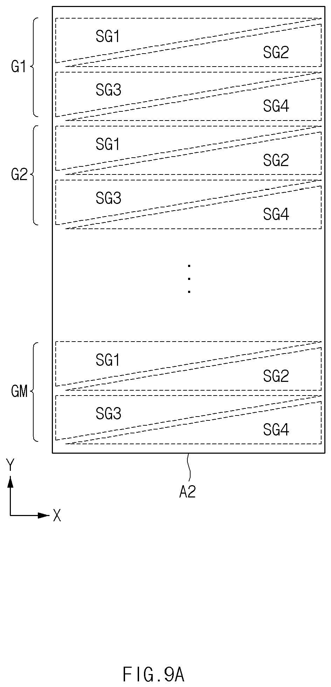

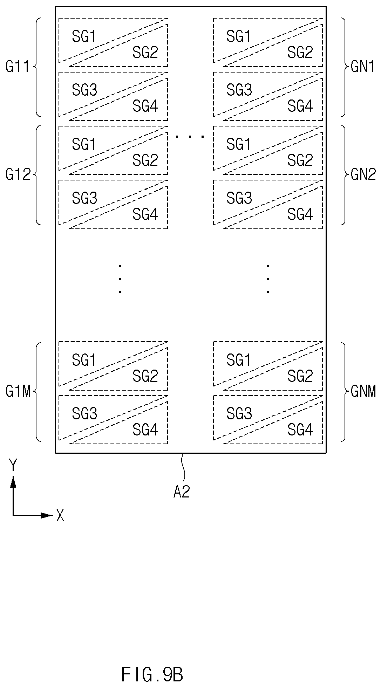

FIGS. 9A and 9B are views illustrating the second area, in which a plurality of strain area groups that may be implemented by the full-bridge circuit are disposed, according to various embodiments.

Referring to FIGS. 7, 9A, and 9B, the second area A2 of the display according to various embodiments may include at least one strain group. The plurality of strain groups may include first to fourth strain areas **SG1,** SG2, SG3, and SG4. A first strain gauge sensor (e.g., the first strain gauge sensor 710 of FIG. 7) may be disposed in the first strain area SG1. A second strain gauge sensor (e.g., the second strain gauge sensor 720 of FIG. 7) may be disposed in the second strain area SG2. A third strain gauge sensor (e.g., the third strain gauge sensor 730 of FIG. 7) may be disposed in the third strain area SG3. A fourth strain gauge sensor (e.g., the fourth strain gauge sensor 740 of FIG. 7) may be disposed in the fourth strain area SG4.

According to an embodiment, one strain sensor group including the first to fourth strain areas SG1, SG2, SG3, and SG4, as illustrated in FIG. 7, may be formed in the second area A2. According to another embodiment, a plurality of strain sensor groups G1, G2, $\cdots$, and GM that are arranged in a row as illustrated in FIG. 9A may be formed in the second area A2. According to another embodiment, a plurality of strain sensor groups G11, G12, $\cdots$, and GM that are arranged in a matrix form (N×M) (here, N and M are natural number that is larger than 1) as illustrated in FIG. 9B may be formed in the second area A2.

According to various embodiments, a half-bridge circuit (e.g., the half-bridge circuit 600 of FIG. 6 or a full-bridge circuit (e.g., the full bridge circuit 800 of FIG. 8) may be implemented by using the first to fourth strain gauge sensors (e.g., the first to fourth strain gauge sensors 710, 720, 730, and 740 included in at least one strain sensor group G1, G2, ···, and GM. Accordingly, temperature is changed at a local portion of the display panel, for example, as in a touch of a screen by the user, the temperature may be precisely compensated for through the plurality of strain sensor groups G1, G2, ··· , and GM implemented by the half-bridge circuit or the full-bridge circuit.

According to various embodiments, the sensitivity of the strain gauge sensor (e.g., the first to fourth strain gauge sensors 710, 720, 730, and 740) may be increased because it is complexly connected to a touch electrode array disposed on the display panel. For example, because the resistance value of the strain gauge sensor may include a component, by which a shape of a touch electrode array is changed, as well as a component, by which the shape of the strain gauge sensor is changed according to the expansion degree of the second area A2, the sensitivity of the strain gauge sensor may be enhanced.

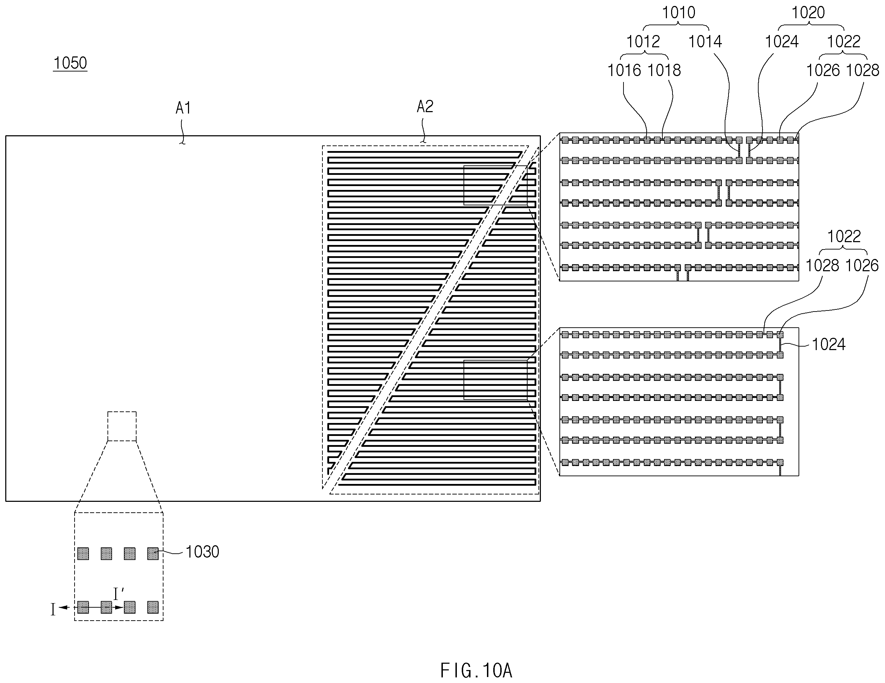

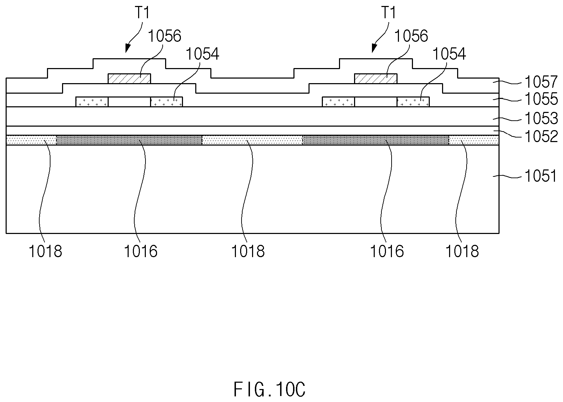

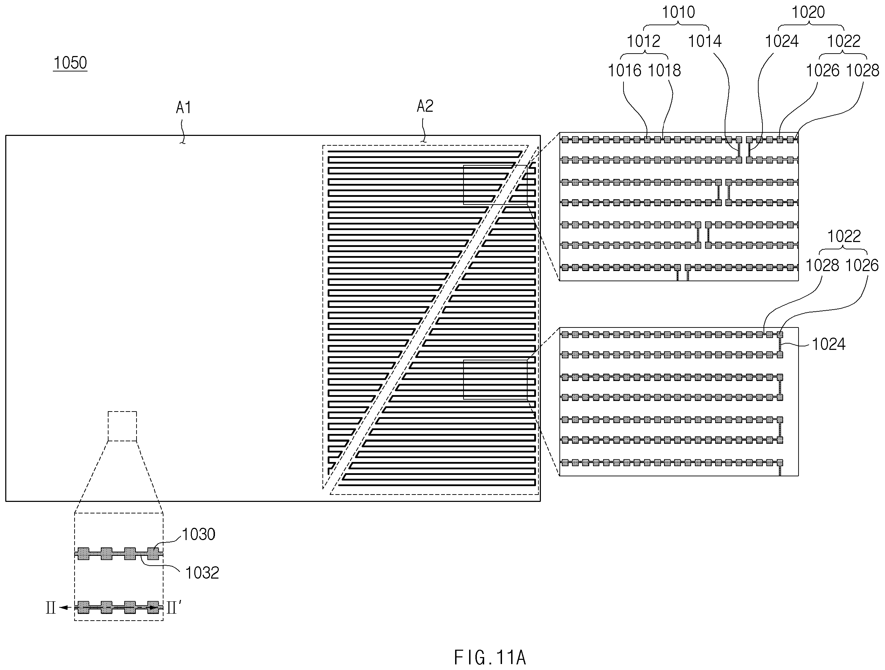

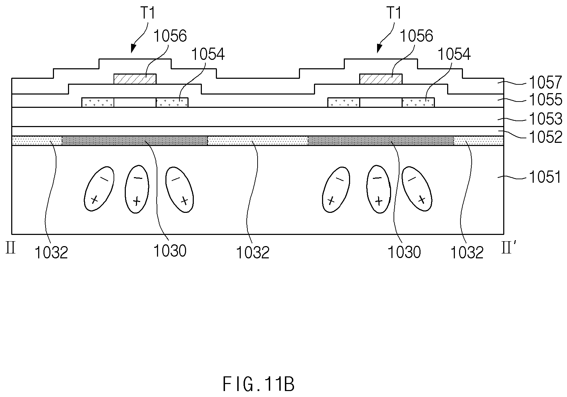

FIGS. 10A to 10C are views illustrating the first strain gauge sensor and the second strain gauge sensor disposed on the substrate of the display according to an embodiment, and FIGS. 11A and 11B are views illustrating a first strain gauge sensor and a second strain gauge sensor disposed on the substrate of the display according to another embodiment. Hereinafter, for convenience of description of a first strain gauge sensor 1010 and a second strain gauge sensor 1020, a first resistance area 1012 including a first sub area 1016 and a second sub area 1018, and a first connection area 1014 will be mainly described, and this also may be applied to a second resistance area 1022 including a third sub area 1026 and a fourth sub area 1028, and a second connection area 1024. For example, the description of the first resistance area 1012 including the first sub area 1016 and the second sub area 1018 may be applied to the description of the second resistance area 1022 including the third sub area 1026 and the fourth sub area 1028, and the description of the first connection area 1014 may be applied to the description of the second connection area 1024.

Referring to FIGS. 10A to 11B, a display 1050 according to various embodiments may include the first area A1 and the second area A2.

A plurality of sub pixels may be disposed in the first area A1 and the second area A2 of the display 1050. At least one thin film transistor may be disposed in each of the plurality of sub pixels. For example, when an image is implemented on the display 1050 by using a light emitting element, each of the plurality of sub pixels may include at least one driving thin film transistor electrically connected to the light emitting element, and at least one switching thin film transistor electrically connected to the driving thin film transistor. At least one of the at least one driving thin film transistor and the at least one switching thin film transistor may include an N type transistor, or the remaining one of the at least one driving thin film transistor and the at least one switching thin film transistor may include a P type transistor.

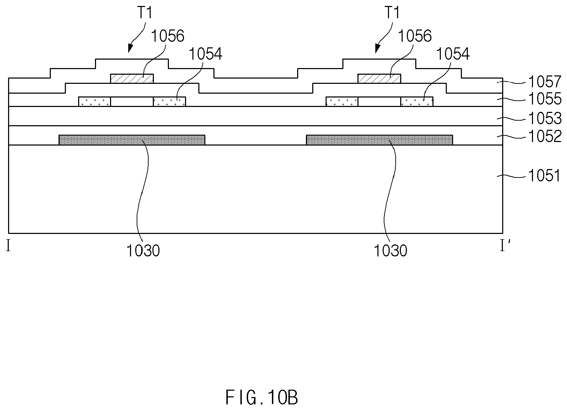

A light shielding layer 1030 may be disposed in the first area A1 of the display. The light shielding layer 1030 may be disposed between at least any one of the at least one driving thin film transistor and the at least one switching transistor, and a substrate 1051. For example, the light shielding layer 1030, as illustrated in FIGS. 10B and 11B, may be disposed between a driving thin film transistor T1 and the substrate 1051. The light shielding layer 1030 may shield the light input to an active layer 1054 of the driving thin film transistor T1. The light shielding layer 1030 may overlap the active layer 1054 of the driving thin film transistor T1 while at least one buffer layer 1052 and 1053 being interposed therebetween. At least one gate insulation film 1055 may be disposed between the active layer 1054 of the driving thin film transistor T1 and a gate electrode 1056. At least one interlayer insulation film 1057 may be disposed on the gate electrode 1056 of the driving thin film transistor T1. At least one of the buffer layer 1052 and 1053, the gate insulation film 1055, and the interlayer insulation film 1057 may be formed of at least any one of an inorganic insulation material and an organic insulation material.

The light shielding layer 1030 according to an embodiment, as illustrated in FIGS. 10A and 10B, may be formed in an island shape to be spaced apart from the adjacent light shielding layer 1030. The light shielding layer 1030 according to an embodiment, as illustrated in FIGS. 11A and 11B, may be formed in a mesh form to be electrically connected to the adjacent light shielding layer 1030 through a bridge 1032. The bridge 1032 may be formed of the same material as that of the light shielding layer 1030. For example, a high-potential voltage VDD may be applied to the light shielding layers 1030 that are electrically connected to each other. The light shielding layers 1030, to which the high-potential voltage VDD is applied, disperse positive charges (+) included in an interior of the substrate 1051, and thus may prevent characteristics of the driving thin film transistor T1 from being changed and prevent stains.

According to an embodiment, the first strain gauge sensor 1010 may include the first resistance area 1012 and the first connection area 1014. The first resistance area 1012 may include the first sub area 1016 and the second sub area 1018. An area of the first sub area 1016 may be larger than that of the second sub area 1018. The first sub area 1016 may have a similar or the same area as that of the light shielding layer 1030 disposed in the first area A1. The second sub area 1018 may connect the first sub areas 1016 between the first sub areas 1016. The second sub area 1018 may be formed in a direction that crosses the first connection area 1014. The second sub area 1018 may reduce an overlapping area with a signal line disposed in the second area A2 and thus may reduce a parasite capacitance formed between the second sub area 1018 and a signal line.

At least any one of the first sub area 1016, the second sub area 1018, and the first connection area 1014 may be formed by using any one of a plurality of conductive layers disposed in at least any one of the first area A1 and the second area A2. For example, at least any one of the first sub area 1016, the second sub area 1018, and the first connection area 1014 may be formed of the same material as that of the light shielding layer 1030, and may be disposed on the same layer (e.g., the substrate 1051) as that of the light shielding layer 1030.

In this way, the first strain gauge sensor 1010 including the first sub area 1016, the second sub area 1018, and the first connection area 1014, and the second strain gauge sensor 1020 including the third sub area 1026, the fourth sub area 1028, and the second connection area 1024 may be formed simultaneously (together) through the same mask process as that of the light shielding layer 1030. Accordingly, the first strain gauge sensor 1010 and the second strain gauge sensor 1020 may be implemented by a large-area strain gauge for high-precision patterning.

According to an embodiment, although the structure, in which the first strain gauge sensor 1010 and the second strain gauge sensor 1020 are disposed between the substrate 1051 and the thin film transistor T1, has been described as an example, the disclosure is not limited thereto, and the first strain gauge sensor 1010 and the second strain gauge sensor 1020 may be variously disposed. According to various embodiments, a metal layer that is operated by the first strain gauge sensor 1010 and the second strain gauge sensor 1020 may be disposed under the substrate 1051.

According to various embodiments, the light shielding layer 1030 may not be disposed in the first area A1. For example, when the plurality of thin film transistors disposed in the first area A1 are formed of low-temperature polycrystalline silicon (LTPS), the light shielding layer 1030 may not be disposed in the first area A1.

According to an embodiment, it has been described that the light shielding layer 1030 has a size, by which the driving thin film transistor T1 included in each of the sub pixels disposed in the first area A1 is shielded, to overlap the driving thin film transistor T1, but the disclosure is not limited thereto, and sizes of the first strain gauge sensor 1010 and the second strain gauge sensor 1020 may be variously changed. According to various embodiments, the light shielding layer 1030 may have a size, by which all of the plurality of thin film transistors included in the sub pixels disposed in the first area A1 are shielded, to overlap all of the plurality of thin film transistors.

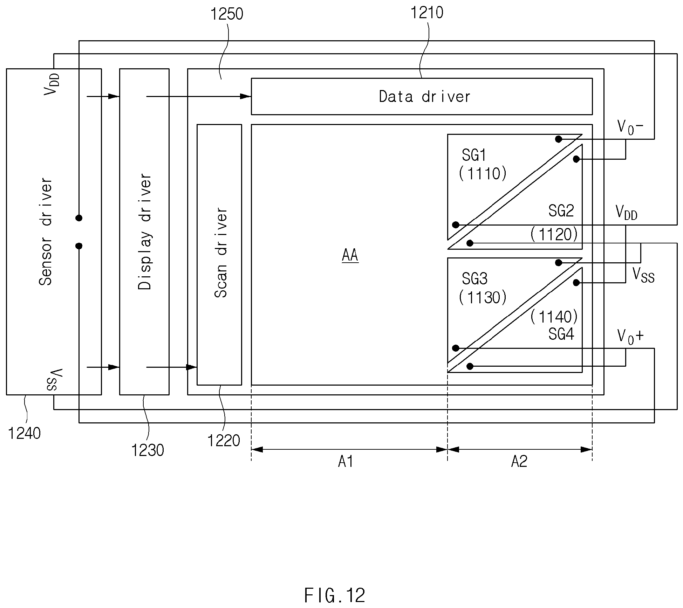

FIG. 12 is a block diagram illustrating an electronic device according to various embodiments including at least one strain sensor group. In FIG. 12, a case, in which one strain sensor group including first to fourth strain sensor areas is disposed in the display panel, will be described as an example.

Referring to FIG. 12, the electronic device according to various embodiments may include a display panel 1250, a scan driver 1220, a display driver 1230, a data driver 1210, and a sensor driver 1240.

The display panel 1250 may include the first area A1 and the second area A2. The plurality of sub pixels may be disposed in a matrix form in the first area A1 and the second area A2. The plurality of sub pixels may be disposed in an area, in which scan lines and data lines cross each other. At least one strain sensor group including the first to fourth strain areas SG1, SG2, SG3, and SG4 may be disposed in the second area A1. A first strain gauge sensor 1110 (e.g., the first strain gauge sensor 710) may be disposed in the first strain area SG1, a second strain gauge sensor 1120 (e.g., the second strain gauge sensor 720) may be disposed in the second strain area SG2, a third strain gauge sensor 1130 (e.g., the third strain gauge sensor 730) may be disposed in the third strain area SG3, and a fourth strain gauge sensor 1140 (e.g., the fourth strain gauge sensor 740) may be disposed in the fourth strain area SG4. The first to fourth strain gauge sensor 1110, 1120, 1130, and 1140 may be formed in a zigzag form that reciprocates forwards and rearwards in a first direction that is the expansion direction of the second area A2. The lengths of the first strain gauge sensor 1110 and the third strain gauge sensor 1130 may become gradually smaller as they go from one side to an opposite side of the second area A2 along a second direction that is different from the first direction. The lengths of the second strain gauge sensor 1120 and the fourth strain gauge sensor 1140 may become gradually larger as they go from one side to an opposite side of the second area A2 along a second direction.

The data driver 1210 is a means for generating a data signal, and may receive image data of R/G/B components from the display driver 1230 and generate a data signal. The data driver 1210 may apply the generated data signal to the sub pixels through data lines formed in the display panel 1250.

The scan driver 1220 may generate scan signals that are sequentially supplied to a plurality of scan lines formed in the display panel 1250. The scan driver 1220 may apply the scan signals to the sub pixels through scan lines.

The sensor driver 1240 may sense the expansion degree of the second area A2 by using changes in the resistance values of the first to fourth strain gauge sensors 1110, 1120, 1130, and 1140, which are changed according to the expansion degree of the second area A2. The sensor driver 1240 may apply an input voltage to the first to fourth strain gauge sensors 1110, 1120, 1130, and 1140. A first input voltage VDD of the same positive polarity may be applied to the first strain gauge sensor 1110 and the fourth strain gauge sensor 1140, and a second input voltage VSS of the same negative polarity may be applied to the second strain gauge sensor 1120 and the third strain gauge sensor 1130. For example, when the display panel 1250 is a light emitting display panel, a high-potential voltage applied to the driving transistor connected to the light emitting element may be used as the first input voltage VDD and a low-potential voltage applied to the cathode terminal of the light emitting element may be used as the second input voltage VSS.

The sensor driver 1240 may be electrically connected to the first to fourth strain gauge sensors 1110, 1120, 1130, and 1140. The sensor driver 1240 may measure changes in the resistance values of the first to fourth strain gauge sensors 1110, 1120, 1130, and 1140 by using output voltages Vo+ and Vo-output from the first to fourth strain gauge sensors 1110, 1120, 1130, and 1140. The sensor driver 1240 may sense the expansion degree of the second area A2 through the changes in the measured resistance values. The sensor driver 1240 may generate an area control signal for determining an extent of a black area (e.g., the black area BA of FIG. 2) of the second area A2 of the display panel 1250 according to the sensed expansion degree of the second area A2.

The display driver 1230 may receive a horizontal synchronization signal Hsync, a vertical synchronization signal Vsync, a main clock signal MCLK, and the like, and may generate an image data signal, a scan control signal, a data control signal, and the like to provide them to the display panel 1250, the data driver 1210, the scan driver 1220, a power supply circuit (not illustrated), and the like.

The display driver 1230 may provide the received image data to the data driver 1210. The display driver 1230 may generate a scan control signal for controlling the scan driver 1220 to control an operation timing of the scan driver 1220. The display driver 1230 may generate a source control signal for controlling the data driver 1210 to control an operation timing of the data driver 1210. According to an embodiment, the display driver 1230 may control an operation of at least any one of the data driver and the scan driver in response to the area control signal generated by the sensor driver 1240. For example, when the electronic device is in the first state (e.g., the first state C1 of FIGS. 1 and 2), the display driver 1230 may control an operation of the data driver 1210 such that no data signal is applied to the sub pixels disposed in the second area A2. When the electronic device is in the second state (e.g., the second state C2 of FIGS. 1 and 2), the display driver 1230 may control an operation of the data driver 1210 such that data signals are supplied to the sub pixels disposed in a partial area of the second area A2, which is exposed to the front surface of the electronic device. The display driver 1230 may control an operation of the data driver 1210 such that no data signal is applied to the sub pixels disposed in the remaining areas of the second area A2, which are not exposed to the front surface of the electronic device. When the electronic device is in the third state (e.g., the third state C3 of FIGS. 1 and 2), the display driver 1230 may control an operation of the data driver 1210 such that data signals are supplied to the sub pixels disposed in the second area A2.

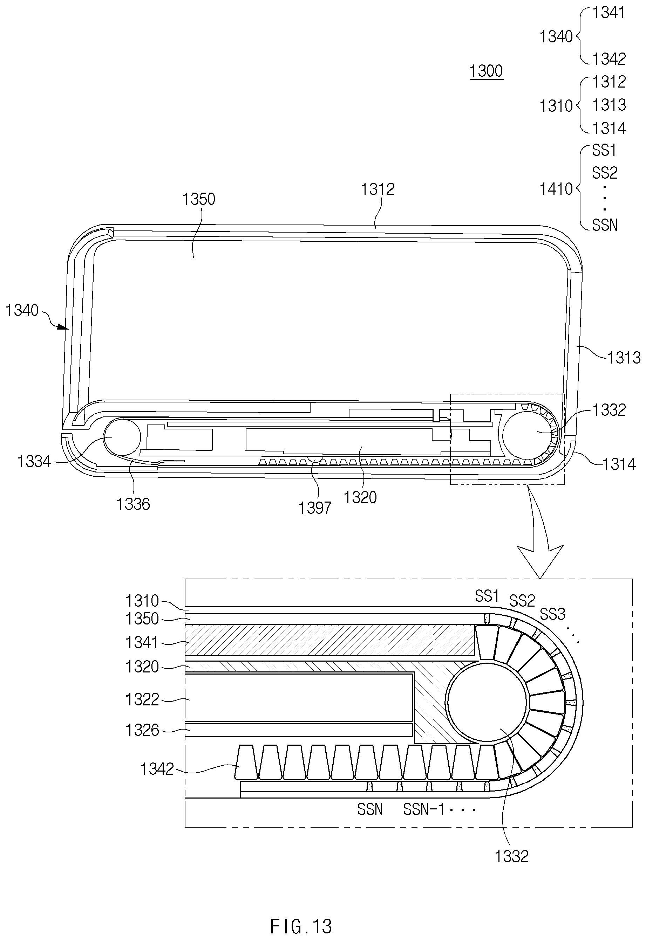

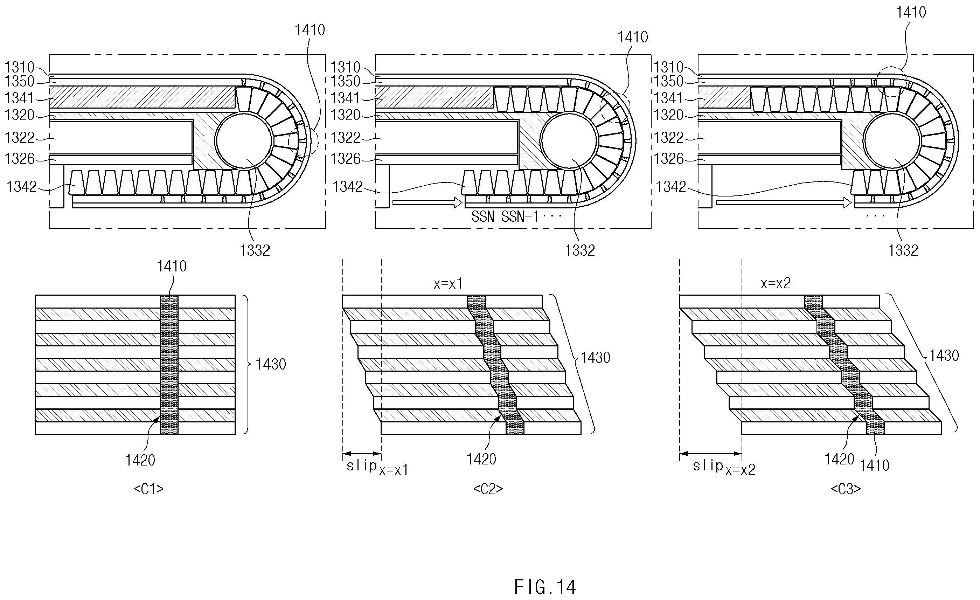

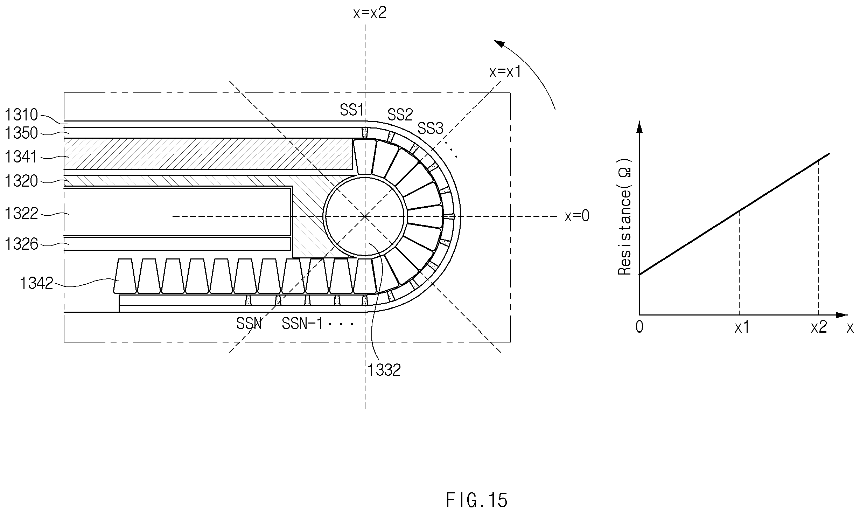

FIG. 13 is a view illustrating the electronic device including the strain gauge sensor embedded in a via hole according to various embodiments. FIG. 14 is a view illustrating degrees of slip for locations of a resistance area included in the strain gauge sensor according to various embodiments. FIG. 15 is a view illustrating resistance values for locations of a strain gauge sensor according to various embodiments.

Referring to FIG. 13, an electronic device 1300 according to various embodiments may include a case 1310, a first structure 1320 (or a first housing), a second structure 1340 (or a second housing), and a display 1350.

The case 1310 may define at least a portion of an outer surface of the electronic device 1300. With respect to the case, the second structure 1340 and the display 1350 may be slid in opposite directions.

The case 1310 may include a first side member 1311, a second side member 1312, and rear members 1313 and 1314. The first side member 1311 and the second side member 1312 may be disposed to face a direction that is substantially perpendicular to a sliding direction (e.g., the first direction D1 and the second direction D2) of the second structure 1340. The rear members 1313 and 1314 may include the frame 1313 and the rear cover 1314. The rear members 1313 and 1314 may be disposed between the first side member 1311 and the second side member 1312, and may be connected to the first side member 1311 and the second side member 1312, respectively.

The first side member 1311 and the second side member 1312 may be disposed at opposite ends of the rear members 1313 and 1314. As the second structure 1340 and/or the display 1350 is slid between the first side member 1311 and the second side member 1312, the second structure 1340 and/or at least a portion of the display 1350 may be inserted into an interior of the case 1310 or drawn from the case 1310. For example, when the electronic device 1300 is strained from the first state C1 to the second state C2 or the third state C3, at least the second structure 1340 and a portion of the display 1350 may be moved in the first direction D1 between the first side member 1311 and the second side member 1312, and another portion of the display 1350 may be moved in the second direction D2. In contrast, when the electronic device 1300 is strained from the second state C2 or the third state C3 to the first state C1, the second structure 1340 and at least a portion of the display 1350 may be moved in the second direction D2 between the first side member 1311 and the second side member 1312, and another portion of the display 1350 may be moved in the first direction D1.

The frame 1313 may be disposed such that at least a portion of the frame 1313 overlaps the second structure 1340 and/or the display 1350. Furthermore, the frame 1313 overlaps the rear cover 1314 to be covered by the rear cover 1314, and thus may not be visually exposed to the user.

The rear cover 1314 may define at least a portion of the rear surface of the electronic device 1300. For example, the rear cover 1314 may be disposed between the first side member 1311 and the second side member 1312. For example, the rear cover 1314 may be disposed such that at least a portion thereof overlaps the frame 1313 such that the frame 1313 is prevented from being exposed to the rear surface of the electronic device 1300.

The first side member 1311, the second side member 1312, and/or the rear member (e.g., the frame 1313 and the rear cover 1314) of the case 1310 may be integrally formed. In another embodiment, the first side member 1311, the second side member 1312, and/or the rear member (e.g., the frame 1313 and/or the rear cover 1314) may be formed as separate configurations, and may be assembled or coupled to each other.

According to various embodiments, the electronic device 1300 may include a first roller member 1332, a second roller member 1334, and a belt member 1336. The second structure 1340 may include a first support area 1341, and a second support area 1342 that extends from the first support area 1341, and may be connected to the first structure 1320 to be slid. The display 1350 may be disposed on at least one surface of the second structure 1340.

The second structure 1340 may be disposed to surround at least a portion of the first structure 1320. For example, at least a portion of the second structure 1340 may be disposed in an upward direction (e.g., the +Z axis direction) of the first structure 1320, and another portion thereof may be disposed in a downward direction (e.g., the -Z axis direction) of the first structure 1320.

A first support part 1341 of the second structure 1340 may be disposed in an upward direction (e.g., the +Z axis direction) of the first structure 1320, and at least a portion of the second support part 1342 may be disposed in a downward direction (e.g., the -Z axis direction) of the first structure 1320.

At least a portion of the second support part 1342 may be disposed in a space between the first structure 1320 and the rear cover 1314. An extent of the second support part 1342 disposed between the first structure 1320 and the rear cover 1314 may be different according to an operational state (e.g., the first to third states C1, C2, and C3) of the electronic device 1300. For example, as the second structure 1340 is slid, at least a portion of the second support part 1342 may be drawn from or inserted into a space between the first structure 1320 and the rear cover 1314. In an embodiment, the display 1350 may be moved together with the second structure 1340. For example, as the second structure 1340 is slid, at least a portion of the display 1350 may be drawn from or inserted into the space between the first structure 1320 and the rear cover 1314, together with the second support part 1342. When the second structure 1340 is slid, at least a portion of the display 1350 may be moved together with the second support part 1342 of the second structure 1340 in correspondence to rotation of the first roller member 1332.

The second structure 1340 may be connected to the first structure 1320 to be slid, by the first roller member 1332, the second roller member 1334, and the belt member 1336.

The second support part 1342 may be disposed to surround at least a portion of the first roller member 1332, and the belt member 1336 may be disposed to surround at least a portion of the second roller member 1334. The first roller member 1332 and the second roller member 1334 may be disposed to be rotated with respect to the first structure 1320. For example, opposite ends of the belt member 1336 may be connected to the first support part 1341 and the second support part 1342 of the second structure 1340, respectively. For example, because the second structure 1340 and the belt member 1336 are connected to each other and the first roller member 1332 and the second roller member 1334 are disposed therebetween, the second structure 1340 and the belt member 1336 may be configured to be slid as the first roller member 1332 and the second roller member 1334 are rotated. In an embodiment, other components 1322 and 1326 of the electronic device 1300 may be disposed in a space between the belt member 1336 and the first structure 1320 and/or a space between the second support part 1342 and the first structure 1320.

The second support area 1342 of the second structure 1340 may include a form (e.g., a multi-joint module), in which a plurality of extending bars are arranged in substantially the same direction as that of a rotation axis of the first roller member 1332. The second support area 1342 may be bent in parts having relatively small thicknesses between the plurality of bars. The second structure 1340 may be referred as another term, such as a flexible track or a hinge rail.

The electronic device 1300 may include the first to third states C1, C2, and C3. For example, the electronic device 1300 may be strained to any one of the first to third states C1, C2, and C3 as the second structure 1340 and the display 1350 are moved in the first direction D1 or the second direction D2 with respect to the case 1310, the first structure 1320, and the rear cover 1314. For example, according to the locations of the second structure 1340 and the display 1350, any one of the first to third states C1, C2, and C3 of the electronic device 1300 may be determined.

When the electronic device 1300 is in the first state, it may be strained to the second state C2 or the third state C3 as at least a portion (e.g., the first support part 1341) of the second structure 1340 is slid in the first direction D1. In contrast, when the electronic device 1300 is in the second state C2 or the third state C3, it may be strained to the first state C1 as at least a portion (e.g., the first support part 1341) of the second structure 1340 is slid in the second direction D2.

A strain gauge sensor 1410 may be formed in the display 1350. The strain gauge sensor 1410 may include a plurality of resistance areas SS1, SS2, ⋯, and SSN that are embedded in via holes 1420 that pass through, among a plurality of thin film layers, thin film layers 1430 of at least two layers. When the electronic device 1300 is in the first state C1, the thin film layers 1430 and the strain gauge sensor 1410 included in the display 1350 may not be strained. For example, a side surface of an uppermost layer and a side surface of a lowermost layer included in the plurality of thin film layers 1430 may coincide with each other.

When the electronic device is in the second state C2 or the third state C3, the thin film layers 1430 included in the display 1350, and the strain gauge sensor 1410 including the plurality of resistance areas SS1, SS2, ⋯, and SSN may be strained. For example, the plurality of thin film layers 1430 and the plurality of resistance areas SS1, SS2, ..., and SSN may be slipped. Slip degrees of the plurality of resistance areas SS1, SS2, ..., and SSN may increase as they become far away from a central axis of the roller member. A length of an arc of, among the plurality of resistance areas SS1, SS2, ⋯, and SSN, a resistance area that is relatively close to a central axis (x=0) of the roller member 1332, the arc being formed while the central axis of the roller member 1332 is a center thereof, may be relatively small. Because a slip degree (x=x1) of the resistance area that is relatively close to the central axis of the roller member 1332 increase by a small degree, the resistance value may be small. A length of an arc of, among the plurality of resistance areas SS1, SS2, $\cdots$, and SSN, a resistance area that is relatively far away from the central axis (x=0) of the roller member 1332, the arc being formed while the central axis of the roller member 1332 is a center thereof, may be relatively large. Because a slip degree (x=x2) of the resistance area that is relatively far away from the central axis of the roller member 1332 increase by a large degree, the resistance value may be large.

In this way, the electronic device 1300 according to an embodiment may include at least one strain gauge sensor (strain gauge), a resistance value of which is different according to the expansion degree of the display 1350. As the second area A2 is expanded, a length of the strain gauge sensor 1410 may increase and a cross-sectional area thereof decrease whereby an electrical resistance value increases. The increased resistance value of the strain gauge sensor 1410 is measured, and thus the expansion degree of the second area A2 may be measured. The resistance of the strain gauge sensor 1410 may increase in proportion of the number of the plurality of resistance areas SS1, SS2, $\cdots$, and SSN included in the strain gauge sensor 1410. Accordingly, the sensitivity of the strain gauge sensor 1410 may be enhanced by increasing the number of the plurality of resistance areas SS1, SS2, $\cdots$, and SSN.

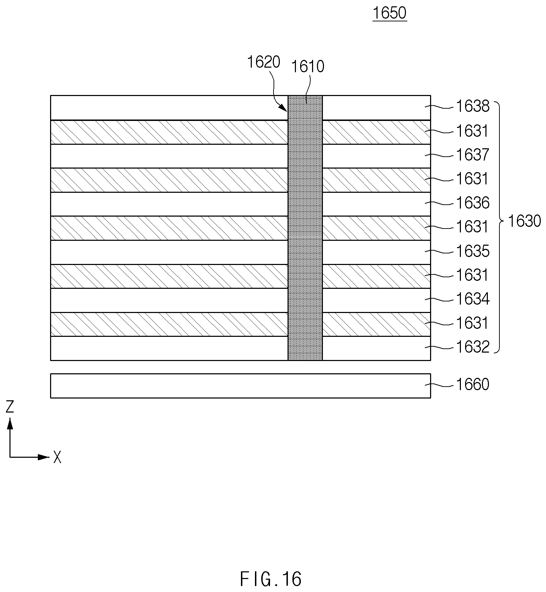

FIG. 16 is a view illustrating the display including a window, to which the strain gauge sensor is applied, according to various embodiments.

Referring to FIG. 16, a display 1650 according to an embodiment may include a display panel 1660 and a window 1630.

The display panel 1660 may include an organic light emitting element or a liquid crystal element. The window 1630 may be attached onto the display panel 1660. The window 1630 may include at least one window substrate 1637 and 1638, at least one bonding layer 1631, and at least one functional layer 1632, 1634, 1635, and 1636.

The at least one window substrate 1637 and 1638 may be a transparent polymer base. For example, the at least one window substrate 1637 and 1638 may include polyimide (PI), polyamide (PA), polyethylene terephthalate (PET), polyethylene naphthalene, poly methyl methacrylate (PMMA), polycarbonate (PC), a copolymer thereof, or a combination thereof, but the disclosure is not limited thereto. For example, the at least one window substrate 1637 and 1638 may include the first window substrate 1637 and the second window substrate 1638. The first window substrate 1637 and the second window substrate 1638 may be formed of the same material or different materials. The first window substrate 1637 may be formed of polyethylene terephthalate (PET), and the second window substrate 1638 may be formed of polyimide (PI). An upper surface (e.g., a surface which the +Z axis faces) of the second window substrate 1638 of the window 1630 may be disposed on a side that is close to the user.

A polarizing plate 1636 may be disposed between a touch sensor layer 1635 and the first window substrate 1637. The polarizing plate 1636 may function to enhance visibility and express a black color precisely by minimizing reflection of external light.

The touch sensor layer 1635 may be disposed between the polarizing plate 1636 and the display panel 1660. The touch sensor layer 1635 may recognize a location of a touch and a change in the location when a hand of a person or an object is touched through the window 1630 and output a touch signal. A location of a touch point is identified from the touch signal of the touch sensor layer 1635, and an image corresponding to the identified location of the touch point may be displayed on the display panel 1660.

The buffer layer 1632 may be located under the window substrates 1637 and 1638 and may function as a cushion that absorbs and/or alleviates an impact that is delivered to a lower side of the window substrates 1637 and 1638. Due to the buffer layer 1632, the impact applied to the window 1630 may be prevented or restrained from being delivered to the display panel 1660. Because the buffer layer 1632 has bonding characteristics, it may be attached onto the display panel 1660. At least one lower film 1634 as well as the buffer layer 1632 may be interposed between the touch sensor layer 1635 and the display panel 1660.

The bonding layer 1631 may be disposed between the thin film layers included in the window 1630 to couple them. The bonding layer 1631 may be disposed between the first window substrate 1637 and the second window substrate 1638. The bonding layer 1631 may be disposed between the first window substrate 1637 and the polarizing plate 1636. The bonding layer 1631 may be disposed between the polarizing plate 1636 and the touch sensor layer 1635. The bonding layer 1631 may be disposed between the touch sensor layer 1635 and the lower film 1634. The bonding layer 1631 may be disposed between the lower film 1634 and the buffer layer 1632. For example, the bonding layer 1631 may include at least one of an optical clear adhesive (OCA), a pressure sensitive adhesive (PSA), a thermal reaction adhesive, and a double-sided tape.

The bonding layer 1631 may distribute stresses between the thin film layers, which are caused as the display is strained, and prevent separation. For example, the bonding layer 1631 having bonding characteristics absorbs stresses cause by path differences of the thin film layers when the display is bent, and thus no slip may occur in the bonding layer 1631.

The window 1630 may include a via hole 1620 that passes through at least any one of the plurality of thin film layers included in the window 1630. For example, the via hole 1620 may be formed to pass from an uppermost layer (e.g., the second window substrate 1638) of the window 1630 to a lowermost layer (e.g., the buffer layer 1632) of the window 1630. A strain gauge sensor 1610 may be disposed in the via hole 1620. The strain gauge sensor 1610 may be formed by embedding a conductive material in the via hole 1620. A length of the strain gauge sensor 1610 may be strained according to the expansion degree of the display whereby the resistance value may be changed. For example, because a length-per-cross-sectional area of the strain gauge sensor 1610 increases as the expansion degree of the display increases, the resistance value may increase.

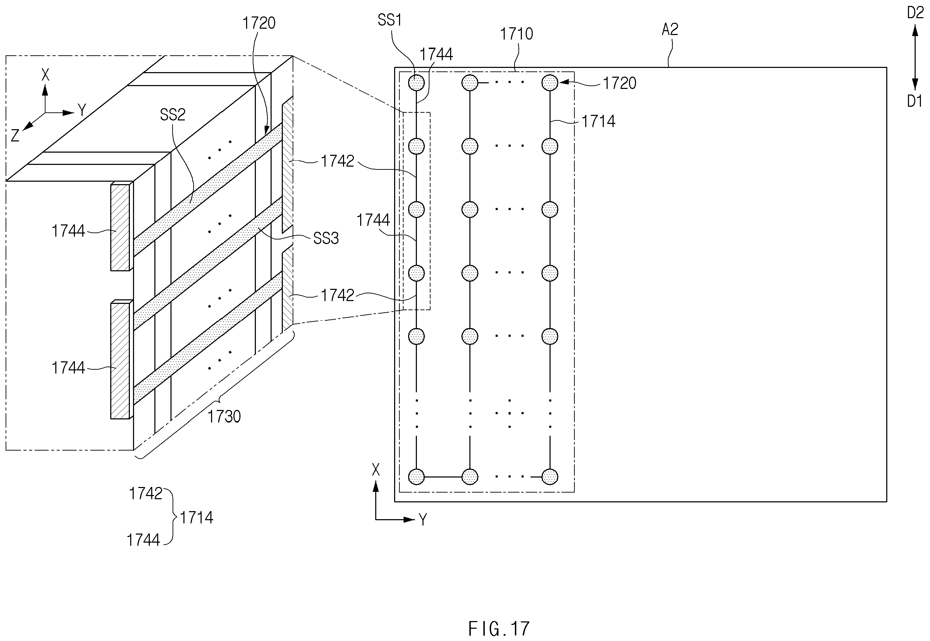

FIG. 17 illustrates views illustrating the second area of the display according to various embodiments in detail.

Referring to FIG. 17, a plurality of via holes 1720 that pass through a multi-thin film layer 1730 may be disposed in the second area of the display. Because the plurality of via holes 1720 are formed to pass through the multi-thin film layer 1730 in a thickness direction (e.g., the Z axis direction) of the multi-thin film layer 1730, a space occupied in the second area A2 may be small.

The resistance areas SS1, SS2, SS3, ... of a strain gauge sensor 1710 may be disposed in the plurality of via holes 1720, respectively. The plurality of strain gauge sensors 1710 may be included in an active area, in which the image of the second area A2 is displayed, or may be disposed in an inactive area, in which no image is displayed. Because the resistance areas SS1, SS2, SS3, ... of the plurality of strain gauge sensors 1710 are embedded in the via holes 1720, a space occupied in the second area A2 may be small. Accordingly, even when the plurality of strain gauge sensor 1710 are disposed in the inactive area, the inactive area may not be significantly increased by the plurality of strain gauge sensor 1710.

The resistance areas SS1, SS2, SS3, ... of the plurality of strain gauge sensors 1710 may be connected to each other through connection members 1714. The connection members 1714 may include a first connection member 1742 and a second connection member 1744.

The first connection member 1742 may contact lower surfaces (e.g., surfaces that face the -Z axis) of the plurality of resistance areas SS1, SS2, SS3, .... The first connection member 1742 may include a conductive layer that is disposed under the plurality of resistance areas SS1, SS2, SS3, ⋯. The second connection member 1744 may contact upper surfaces (e.g., surfaces that face the +Z axis) of the plurality of resistance areas SS1, SS2, SS3, ⋯. The second connection member 1744 may be formed through a patterning process using the conductive layer disposed on the plurality of resistance areas SS1, SS2, SS3, ... , or may be formed through the same masking process using the conductive layer of the same material as that of the plurality of strain gauge sensors 1710. Because the first connection members 1742 and the second connection members 1744 are alternately disposed, the plurality of strain gauge sensors 1710 including the plurality of resistance areas SS1, SS2, SS3, ⋯, the first connection members 1742, and the second connection members 1744 may be disposed in a zigzag form. For example, the plurality of strain gauge sensors 1710 may be formed in a zigzag form that reciprocates forwards and rearwards in a stack direction (e.g., the +Z axis direction or the -Z axis direction) of the multi-thin film layer 1730.

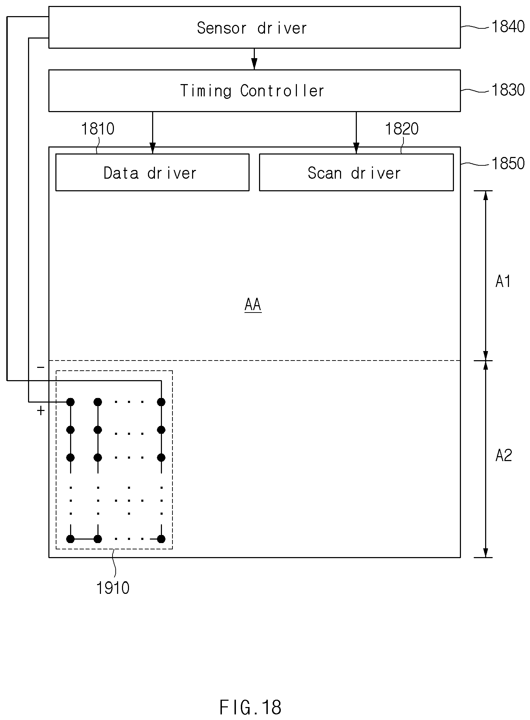

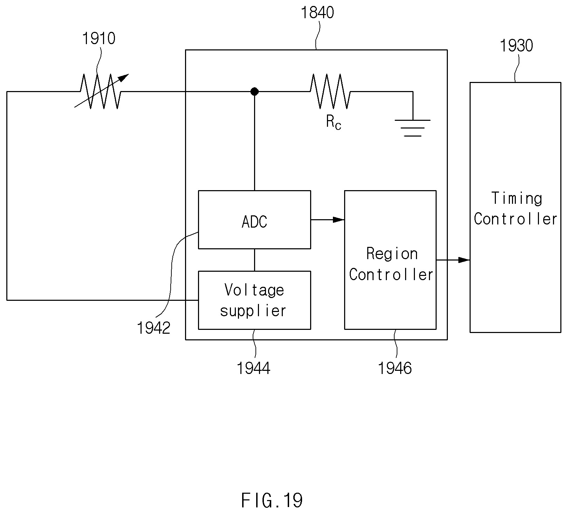

FIG. 18 is a block diagram illustrating the electronic device including the display, in which the plurality of strain gauge sensors are disposed, according to various embodiments, and FIG. 19 is a block diagram illustrating the sensor driver illustrated in FIG. 18 in detail.

Referring to FIG. 18, the electronic device according to various embodiments may include a display panel 1850, a scan driver 1820, a timing controller 1830, a data driver 1810, and a sensor driver 1840.

The display panel 1850 may include the first area A1 and the second area A2. A plurality of sub pixels may be disposed in a matrix form in the first area A1 and the second area A2 of the display panel 1850. The plurality of sub pixels may be disposed in an area, in which they cross the scan lines and the data lines.

At least one strain gauge sensor 1910 (e.g., the strain gauge sensor 1710 of FIG. 17) may be disposed in the second area A2. The strain gauge sensor 1910 may sense the expansion degree of the second area A2 as the resistance value thereof is changed along the expansion direction of the second area A2.

The data driver 1810 may receive image data of R/G/B components from the timing controller 1830 and generate data signals. The data driver 1810 may apply the generated data signals to the sub pixels through data lines formed in the display panel 1850.

The scan driver 1820 may generate scan signals that are sequentially supplied to the plurality of scan lines formed in the display panel 1850. The scan driver 1820 may apply the scan signals to the sub pixels through the scan lines.

The sensor driver 1840 may sense the expansion degree of the second area A2 by using at least one strain gauge sensor 1910, a resistance value of which is changed according to the expansion degree of the second area A2. The sensor driver 1840, as illustrated in FIG. 19, may include a voltage supply part 1944, an analog-digital converter 1942, and an area controller 1946.

The voltage supply part 1944 may apply an input voltage to the strain gauge sensor. A first input voltage of a positive polarity may be applied to a first input terminal of the strain gauge sensor 1910, and a second input voltage of a negative polarity may be applied to a second input terminal thereof. For example, when the display panel 1850 is a light emitting display panel, a high-potential voltage applied to a driving transistor connected to a light emitting element may be used as the first input voltage VDD, and a low-potential voltage applied to a cathode terminal of the light emitting element may be used as the second input voltage VSS.

An input voltage supplied to the strain gauge sensor 1910 may be divided by the strain gauge sensor 1910 and a filter resistor Rc and may be provided to the analog-digital converter 1942 as a sensing voltage. The sensing voltage may be changed according to the resistance value of the strain gauge sensor 1910, which is changed according to the expansion degree of the second area A2. The analog-digital converter 1942 may convert the sensing voltage in an analog form, which is received from the strain gauge sensor, to a sensing signal in a digital form.

The area controller 1946 may control a driving area of the second area A2 based on the sensing signal. The area controller 1946 may supply an area control signal corresponding to the sensing signal to the timing controller 1830.

The timing controller 1830 may provide the received input image data to the data driver 306. The timing controller 1830 may generate a scan control signal for controlling the scan driver 1820 and control an operation timing of the scan driver 1820. The timing controller 1830 may generate a source control signal for controlling the data driver 1810 and control an operation timing of the data driver 1810.

In an embodiment, the timing controller 1830 may control at least one operation of the data driver 1810 and the scan driver 1820 in response to the area control signal generated by the sensor driver 1840. For example, when the electronic device is in the first state (e.g., the first state C1 of FIGS. 1 and 2), the timing controller 1830 may control an operation of the data driver 1210 such that the data signals are supplied to the sub pixels disposed in the second area A2 in response to the area control signal. When the electronic device is in the second state (e.g., the second state C2 of FIGS. 1 and 2), the timing controller 1830 may control an operation of the data driver 1210 such that the data signal are supplied to some sub pixels disposed in the second area A2 and the data signal are not supplied to the remaining sub pixels in response to the area control signal. When the electronic device is in the third state (e.g., the third state C3 of FIGS. 1 and 2), the timing controller 1830 may control an operation of the data driver 1210 such that the data signals are not supplied to the sub pixels disposed in the second area A2 in response to the area control signal.

The display including the strain gauge sensor according to various embodiments disclosed in the disclosure may be included in the electronic device of various forms.

FIG. 1 is a block diagram illustrating an electronic device in a network environment according to an embodiment of the disclosure.

Referring to FIG. 1, an electronic device 101 in a network environment 200 may communicate with an electronic device 102 via a first network 198 (e.g., a short-range wireless communication network), or an electronic device 104 or a server 108 via a second network 199 (e.g., a long-range wireless communication network). According to an embodiment, the electronic device 101 may communicate with the electronic device 104 via the server 108. According to an embodiment, the electronic device 101 may include a processor 120, memory 130, an input device 250, a sound output device 155, a display device 160, an audio module 170, a sensor module 176, an interface 177, a haptic module 179, a camera module 180, a power management module 188, a battery 189, a communication module 190, a subscriber identification module (SIM) 196, or an antenna module 197. In some embodiments, at least one (e.g., the display device 160 or the camera module 180) of the components may be omitted from the electronic device 101, or one or more other components may be added in the electronic device 101. In some embodiments, some of the components may be implemented as single integrated circuitry. For example, the sensor module 176 (e.g., a fingerprint sensor, an iris sensor, or an illuminance sensor) may be implemented as embedded in the display device 160 (e.g., a display).

The processor 120 may execute, for example, software (e.g., a program 240) to control at least one other component (e.g., a hardware or software component) of the electronic device 101 coupled with the processor 120, and may perform various data processing or computation. According to one embodiment, as at least part of the data processing or computation, the processor 120 may load a command or data received from another component (e.g., the sensor module 176 or the communication module 190) in volatile memory 132, process the command or the data stored in the volatile memory 132, and store resulting data in non-volatile memory 134. According to an embodiment, the processor 120 may include a main processor 121 (e.g., a central processing unit (CPU) or an application processor (AP)), and an auxiliary processor 123 (e.g., a graphics processing unit (GPU), an image signal processor (ISP), a sensor hub processor, or a communication processor (CP)) that is operable independently from, or in conjunction with, the main processor 121. Additionally or alternatively, the auxiliary processor 123 may be adapted to consume less power than the main processor 121, or to be specific to a specified function. The auxiliary processor 123 may be implemented as separate from, or as part of the main processor 121.

The auxiliary processor 123 may control at least some of functions or states related to at least one component (e.g., the display device 160, the sensor module 176, or the communication module 190) among the components of the electronic device 101, instead of the main processor 121 while the main processor 121 is in an inactive (e.g., sleep) state, or together with the main processor 121 while the main processor 121 is in an active state (e.g., executing an application). According to an embodiment, the auxiliary processor 123 (e.g., an image signal processor or a communication processor) may be implemented as part of another component (e.g., the camera module 180 or the communication module 190) functionally related to the auxiliary processor 123.

The memory 130 may store various data used by at least one component (e.g., the processor 120 or the sensor module 176) of the electronic device 101. The various data may include, for example, software (e.g., the program 240) and input data or output data for a command related thereto. The memory 130 may include the volatile memory 132 or the non-volatile memory 134. The memory 130 may include internal memory 136 or external memory 138.

The program 240 may be stored in the memory 130 as software, and may include, for example, an operating system (OS) 142, middleware 144, or an application 146.

The input device 250 may receive a command or data to be used by other component (e.g., the processor 120) of the electronic device 101, from the outside (e.g., a user) of the electronic device 101. The input device 250 may include, for example, a microphone, a mouse, a keyboard, or a digital pen (e.g., a stylus pen).

The sound output device 155 may output sound signals to the outside of the electronic device 101. The sound output device 155 may include, for example, a speaker or a receiver. The speaker may be used for general purposes, such as playing multimedia or playing record, and the receiver may be used for an incoming calls. According to an embodiment, the receiver may be implemented as separate from, or as part of the speaker.

The display device 160 may visually provide information to the outside (e.g., a user) of the electronic device 101. The display device 160 may include, for example, a display, a hologram device, or a projector and control circuitry to control a corresponding one of the display, hologram device, and projector. According to an embodiment, the display device 160 may include touch circuitry adapted to detect a touch, or sensor circuitry (e.g., a pressure sensor) adapted to measure the intensity of force incurred by the touch.

The audio module 170 may convert a sound into an electrical signal and vice versa. According to an embodiment, the audio module 170 may obtain the sound via the input device 250, or output the sound via the sound output device 155 or a headphone of an external electronic device (e.g., an electronic device 102) directly (e.g., wiredly) or wirelessly coupled with the electronic device 101.

The sensor module 176 may detect an operational state (e.g., power or temperature) of the electronic device 101 or an environmental state (e.g., a state of a user) external to the electronic device 101, and then generate an electrical signal or data value corresponding to the detected state. According to an embodiment, the sensor module 176 may include, for example, a gesture sensor, a gyro sensor, an atmospheric pressure sensor, a magnetic sensor, an acceleration sensor, a grip sensor, a proximity sensor, a color sensor, an infrared (IR) sensor, a biometric sensor, a temperature sensor, a humidity sensor, or an illuminance sensor.

The interface 177 may support one or more specified protocols to be used for the electronic device 101 to be coupled with the external electronic device (e.g., the electronic device 102) directly (e.g., wiredly) or wirelessly. According to an embodiment, the interface 177 may include, for example, a high definition multimedia interface (HDMI), a universal serial bus (USB) interface, a secure digital (SD) card interface, or an audio interface.

A connecting terminal 178 may include a connector via which the electronic device 101 may be physically connected with the external electronic device (e.g., the electronic device 102). According to an embodiment, the connecting terminal 178 may include, for example, a HDMI connector, a USB connector, a SD card connector, or an audio connector (e.g., a headphone connector).

The haptic module 179 may convert an electrical signal into a mechanical stimulus (e.g., a vibration or a movement) or electrical stimulus which may be recognized by a user via his tactile sensation or kinesthetic sensation. According to an embodiment, the haptic module 179 may include, for example, a motor, a piezoelectric element, or an electric stimulator.

The camera module 180 may capture a still image or moving images. According to an embodiment, the camera module 180 may include one or more lenses, image sensors, image signal processors, or flashes.

The power management module 188 may manage power supplied to the electronic device 101. According to one embodiment, the power management module 188 may be implemented as at least part of, for example, a power management integrated circuit (PMIC).

The battery 189 may supply power to at least one component of the electronic device 101. According to an embodiment, the battery 189 may include, for example, a primary cell which is not rechargeable, a secondary cell which is rechargeable, or a fuel cell.

The communication module 190 may support establishing a direct (e.g., wired) communication channel or a wireless communication channel between the electronic device 101 and the external electronic device (e.g., the electronic device 102, the electronic device 104, or the server 108) and performing communication via the established communication channel. The communication module 190 may include one or more communication processors that are operable independently from the processor 120 (e.g., the application processor (AP)) and supports a direct (e.g., wired) communication or a wireless communication. According to an embodiment, the communication module 190 may include a wireless communication module 192 (e.g., a cellular communication module, a short-range wireless communication module, or a global navigation satellite system (GNSS) communication module) or a wired communication module 194 (e.g., a local area network (LAN) communication module or a power line communication (PLC) module). A corresponding one of these communication modules may communicate with the external electronic device via the first network 198 (e.g., a short-range communication network, such as Bluetooth™, wireless-fidelity (Wi-Fi) direct, or infrared data association (IrDA)) or the second network 199 (e.g., a long-range communication network, such as a cellular network, the Internet, or a computer network (e.g., LAN or wide area network (WAN)). These various types of communication modules may be implemented as a single component (e.g., a single chip), or may be implemented as multi components (e.g., multi chips) separate from each other. The wireless communication module 192 may identify and authenticate the electronic device 101 in a communication network, such as the first network 198 or the second network 199, using subscriber information (e.g., international mobile subscriber identity (IMSI)) stored in the subscriber identification module 196.

The antenna module 197 may transmit or receive a signal or power to or from the outside (e.g., the external electronic device) of the electronic device 101. According to an embodiment, the antenna module 197 may include an antenna including a radiating element composed of a conductive material or a conductive pattern formed in or on a substrate (e.g., PCB). According to an embodiment, the antenna module 197 may include a plurality of antennas. In such a case, at least one antenna appropriate for a communication scheme used in the communication network, such as the first network 198 or the second network 199, may be selected, for example, by the communication module 190 (e.g., the wireless communication module 192) from the plurality of antennas. The signal or the power may then be transmitted or received between the communication module 190 and the external electronic device via the selected at least one antenna. According to an embodiment, another component (e.g., a radio frequency integrated circuit (RFIC)) other than the radiating element may be additionally formed as part of the antenna module 197.

At least some of the above-described components may be coupled mutually and communicate signals (e.g., commands or data) therebetween via an inter-peripheral communication scheme (e.g., a bus, general purpose input and output (GPIO), serial peripheral interface (SPI), or mobile industry processor interface (MIPI)).

According to an embodiment, commands or data may be transmitted or received between the electronic device 101 and the external electronic device 104 via the server 108 coupled with the second network 199. Each of the electronic devices 102 and 104 may be a device of a same type as, or a different type, from the electronic device 101. According to an embodiment, all or some of operations to be executed at the electronic device 101 may be executed at one or more of the external electronic devices 102, 104, or 108. For example, if the electronic device 101 should perform a function or a service automatically, or in response to a request from a user or another device, the electronic device 101, instead of, or in addition to, executing the function or the service, may request the one or more external electronic devices to perform at least part of the function or the service. The one or more external electronic devices receiving the request may perform the at least part of the function or the service requested, or an additional function or an additional service related to the request, and transfer an outcome of the performing to the electronic device 101. The electronic device 101 may provide the outcome, with or without further processing of the outcome, as at least part of a reply to the request. To that end, a cloud computing, distributed computing, or client-server computing technology may be used, for example.

According to various embodiments of the disclosure, a display may include a first area that is an active area, at least one second area disposed in parallel to the first area and being expandable from the first area, a first strain gauge sensor disposed in the second area, and formed in a zigzag form in a first direction that is an expansion direction of the second area, and a second strain gauge sensor disposed to be spaced apart from the first strain gauge sensor in the second area, and formed in a zigzag form in the first direction, the first strain gauge sensor may include a plurality of first resistance areas, lengths of which become gradually smaller as they go from one side to an opposite side of the second area along a second direction that is different from the first direction, and a plurality of first connection areas connecting the plurality of first resistance areas, and the second strain gauge sensor may include a plurality of second resistance areas, lengths of which become gradually larger as they go from one side to an opposite side of the second area, and a plurality of second connection areas connecting the plurality of second resistance areas.

According to various embodiments of the disclosure, the display may further include a conductive layer disposed on a substrate of the first area, and at least one of the first resistance area, the second resistance area, the first connection area, and the second connection area may be formed of the same material as that of the conductive layer and is disposed on the same plane as that of the conductive layer.

According to various embodiments of the disclosure, the display may further include a light shielding layer disposed on a substrate of the first area, and at least any one of the first resistance area, the second resistance area, the first connection area, and the second connection area may be formed of the same material as that of the light shielding layer and is disposed on the same plane as that of the light shielding layer.

According to various embodiments of the disclosure, the display may further include a driving transistor overlapping the light shielding layer, and a light emitting element connected to the driving transistor.

According to various embodiments of the disclosure, a high-potential voltage applied to the light shielding layer may be supplied to the first strain gauge sensor, and a low-potential voltage applied to a cathode terminal of the light emitting element may be supplied to the second strain gauge sensor.

According to various embodiments of the disclosure, at least any one of the first resistance area and the second resistance area may include a first sub area overlapping an active layer of the driving thin film transistor, and a second sub area not overlapping the active layer of the driving thin film transistor.

According to various embodiments of the disclosure, a strain of the first strain gauge sensor may decrease and a strain of the second strain gauge sensor may increase as the second area is expanded.

According to various embodiments of the disclosure, the display may further include a third strain gauge sensor spaced apart from the second strain gauge sensor in the second direction, and having the same shape as that of the first strain gauge sensor, and a fourth strain gauge sensor spaced apart from the third strain gauge sensor in the first direction, and having the same shape as that of the second strain gauge sensor.

According to various embodiments of the disclosure, a high-potential voltage applied to the light shielding layer may be supplied to at least any one of the first strain gauge sensor and the fourth strain gauge sensor, and a low-potential voltage applied to a cathode terminal of the light emitting element may be supplied to at least any one of the second strain gauge sensor and the third strain gauge sensor.

According to various embodiments of the disclosure, the first strain gauge sensor, the second strain gauge sensor, the third strain gauge sensor, and the fourth strain gauge sensor may be disposed repeatedly at least once in at least any one of the first direction and the second direction.

According to various embodiments of the disclosure, strains of the first strain gauge sensor and the third strain gauge sensor may decrease and strains of the second strain gauge sensor and the fourth strain gauge sensor may increase as an extent of the second area exposed to an outside increases.

According to various embodiments of the disclosure, the third strain gauge sensor may include a plurality of third resistance areas, lengths of which become gradually smaller as they go from one side to an opposite side of the second area, and a plurality of third connection areas connecting the plurality of third resistance areas, and the fourth strain gauge sensor may include a plurality of fourth resistance areas, lengths of which become gradually larger as they go from one side to an opposite side of the second area, and a plurality of fourth connection areas connecting the plurality of fourth resistance areas.

According to various embodiments of the disclosure, at least any one of the third resistance area, the fourth resistance area, the third connection area, and the fourth connection area may be formed of the same material as that of the light shielding layer and is disposed on the same plane as that of the light shielding layer.

According to various embodiments of the disclosure, at least any one of the first resistance area, the second resistance area, the third resistance area, and the fourth resistance area may include a first sub area overlapping an active layer of the driving thin film transistor, and a second sub area not overlapping the active layer of the driving thin film transistor.

According to various embodiments of the disclosure, a width of the second sub area in the second direction may be smaller than that of the first sub area.

According to various embodiments of the disclosure, an electronic device may include a display including a first area exposed to a front surface of the electronic device and at least one second area disposed in parallel to the first area and exposed to the front surface of the electronic device, a first strain gauge sensor disposed in the second area, and a resistance value of which is changed in inverse proportion to an exposure extent of the second area, a second strain gauge sensor disposed to be spaced apart from the first strain gauge sensor in the second area, and a resistance value of which is changed in proportion to an exposure extent of the second area, and a sensor driver that senses changes in the resistance values of the first strain gauge sensor and the second strain gauge sensor to sense an exposure degree of the second area.

According to various embodiments of the disclosure, the first strain gauge sensor may be formed in a zigzag form in a first direction that is an exposure direction of the second area, and a length thereof becomes gradually smaller as it goes from one side to an opposite side of the second area along a second direction that is different from the first direction, and the second strain gauge sensor is formed in a zigzag form in the first direction, and a length thereof may become gradually smaller as it goes from one side to an opposite side of the second area.

According to various embodiments of the disclosure, the sensor driver may determine an extent of a black area of the second area according to the sensed exposure degree of the second area.

According to various embodiments of the disclosure, the electronic device may further include a third strain gauge sensor spaced apart from the second strain gauge sensor in the second direction, and having the same shape as that of the first strain gauge sensor, and a fourth strain gauge sensor spaced apart from the third strain gauge sensor in the first direction, and having the same shape as that of the second strain gauge sensor.

According to various embodiments of the disclosure, the electronic device may further include a light shielding layer disposed on a substrate in the first area, and at least any one of the first strain gauge sensor, the second strain gauge sensor, the third strain gauge sensor, and the fourth strain gauge sensor may be formed of the same material as that of the light shielding layer and is disposed on the same plane as that of the light shielding layer.

Various embodiments of the disclosure and terms used herein are not intended to limit the technologies described in the disclosure to specific embodiments, and it should be understood that the embodiments and the terms include modification, equivalent, and/or alternative on the corresponding embodiments described herein. With regard to description of drawings, similar elements may be marked by similar reference numerals. The terms of a singular form may include plural forms unless otherwise specified. In the disclosure disclosed herein, the expressions "A or B", "at least one of A and/or B", "at least one of A and/or B", "A, B, or C", or "at least one of A, B, and/or C", and the like used herein may include any and all combinations of one or more of the associated listed items. Expressions such as "first," or "second," and the like, may express their elements regardless of their priority or importance and may be used to distinguish one element from another element but is not limited to these components. When an (e.g., first) element is referred to as being "(operatively or communicatively) coupled with/to" or "connected to" another (e.g., second) element, it may be directly coupled with/to or connected to the other element or an intervening element (e.g., a third element) may be present.

According to the situation, the expression "adapted to or configured to" used herein may be interchangeably used as, for example, the expression "suitable for", "having the capacity to", "changed to", "made to", "capable of" or "designed to" in hardware or software. The expression "a device configured to" may mean that the device is "capable of" operating together with another device or other components. For example, a "processor configured to (or set to) perform A, B, and C" may mean a dedicated processor (e.g., an embedded processor) for performing corresponding operations or a generic-purpose processor (e.g., a central processing unit (CPU) or an application processor) which performs corresponding operations by executing one or more software programs which are stored in a memory device (e.g., the memory 130).

The term "module" used herein may include a unit, which is implemented with hardware, software, or firmware, and may be interchangeably used with the terms "logic", "logical block", "component", "circuit", or the like. The "module" may be a minimum unit of an integrated component or a part thereof or may be a minimum unit for performing one or more functions or a part thereof. The "module" may be implemented mechanically or electronically and may include, for example, an application-specific IC (ASIC) chip, a field-programmable gate array (FPGA), and a programmable-logic device for performing some operations, which are known or will be developed.

According to various embodiments, at least a part of an apparatus (e.g., modules or functions thereof) or a method (e.g., operations) may be, for example, implemented by instructions stored in a computer-readable storage media (e.g., the memory 130) in the form of a program module. The instruction, when executed by a processor (e.g., a processor 120), may cause the processor to perform a function corresponding to the instruction. The computer-readable recording medium may include a hard disk, a floppy disk, a magnetic media (e.g., a magnetic tape), an optical media (e.g., a compact disc read only memory (CD-ROM) and a digital versatile disc (DVD), a magneto-optical media (e.g., a floptical disk)), an embedded memory, and the like. The one or more instructions may contain a code made by a compiler or a code executable by an interpreter.

Each element (e.g., a module or a program module) according to various embodiments may be composed of single entity or a plurality of entities, a part of the above-described sub-elements may be omitted or may further include other sub-elements. Alternatively or additionally, after being integrated in one entity, some elements (e.g., a module or a program module) may identically or similarly perform the function executed by each corresponding element before integration. According to various embodiments, operations executed by modules, program modules, or other elements may be executed by a successive method, a parallel method, a repeated method, or a heuristic method, or at least one part of operations may be executed in different sequences or omitted. Alternatively, other operations may be added.

**Claims**

1.  A display comprising:

    a first area (A1) that is an active area;
    a second area (A2) disposed in parallel to the first area (A1) and being expandable from the first area (A1);
    a first strain gauge sensor (410, 710, 1010, 1110) disposed in the second area (A2), and formed in a zigzag form in a first direction that is an expansion direction of the second area (A2); and
    a second strain gauge sensor (420, 720, 1020, 1120) disposed to be spaced apart from the first strain gauge sensor (410) in the second area (A2), and formed in a zigzag form in the first direction,
    wherein the first strain gauge sensor (410, 710, 1010, 1110) includes:

        a plurality of first resistance areas (412, 712, 1012), lengths of which become gradually smaller as they go from one side to an opposite side of the second area (A2) along a second direction that is different from the first direction; and
        a plurality of first connection areas (414, 714, 1014) connecting the plurality of first resistance areas (412, 712, 1012), and
        wherein the second strain gauge sensor (420, 720, 1020, 1120) includes:

            a plurality of second resistance areas (422, 722, 1022), lengths of which become gradually larger as they go from one side to an opposite side of the second area (A2); and
a plurality of second connection areas (424, 724, 1024) connecting the plurality of second resistance areas (422, 722, 1022).

2. The display of claim 1, further comprising:

a conductive layer disposed on a substrate of the first area (A1),
wherein at least one of the first resistance area (412, 712, 1012), the second resistance area (422, 722, 1022), the first connection area (414, 714, 1014), and the second connection area (424, 724, 1024) is formed of the same material as that of the conductive layer and is disposed on the same plane as that of the conductive layer.

3. The display of claim 1, further comprising:

a light shielding layer (1030) disposed on a substrate of the first area (A1),
wherein at least any one of the first resistance area (1012), the second resistance area (1022), the first connection area (1014), and the second connection area (1024) is formed of the same material as that of the light shielding layer and is disposed on the same plane as that of the light shielding layer (1030).

4. The display of claim 3, further comprising:

a driving transistor (T1) overlapping the light shielding layer (1030); and
a light emitting element connected to the driving transistor.

5. The display of claim 4, wherein a high-potential voltage applied to the light shielding layer (1030) is supplied to the first strain gauge sensor (410,710, 1010), and
wherein a low-potential voltage applied to a cathode terminal of the light emitting element is supplied to the second strain gauge sensor (420, 720, 1020).

6. The display of claim 4, wherein at least any one of the first resistance area (1012) and the second resistance area (1022) includes:

a first sub area (1016) overlapping an active layer of the driving thin film transistor; and
a second sub area (1018) not overlapping the active layer of the driving thin film transistor.

7. The display of claim 1, wherein a strain of the first strain gauge sensor (410,710,1010) decreases and a strain of the second strain gauge sensor (420, 720, 1020) increases as the second area (A2) is expanded.

8. The display of claim 4, further comprising:

a third strain gauge sensor (730, 1130) spaced apart from the second strain gauge sensor (720,1120) in the second direction, and having the same shape as that of the first strain gauge sensor (710,1110); and
a fourth strain gauge sensor (740, 1140) spaced apart from the third strain gauge sensor (730,1130) in the first direction, and having the same shape as that of the second strain gauge sensor (720,1120).

9. The display of claim 8, wherein a high-potential voltage applied to the light shielding layer (1030) is supplied to at least any one of the first strain gauge sensor (710,1110) and the fourth strain gauge sensor (740, 1140), and
wherein a low-potential voltage applied to a cathode terminal of the light emitting element is supplied to at least any one of the second strain gauge sensor (720,1120) and the third strain gauge sensor (730, 1130).

10. The display of claim 8, wherein the first strain gauge sensor (710,1110), the second strain gauge sensor(720,1120), the third strain gauge sensor(730,1130), and the fourth strain gauge sensor (740,1140) are disposed repeatedly at least once in at least any one of the first direction and the second direction.

11. The display of claim 8, wherein strains of the first strain gauge sensor (710,1110) and the third strain gauge sensor (730,1130) decrease and strains of the second strain gauge sensor (720,1120) and the fourth strain gauge sensor (740,1140) increase as an extent of the second area exposed to an outside increases.

12. The display of claim 8, wherein the third strain gauge sensor (730,1130) includes:

a plurality of third resistance area (732) s, lengths of which become gradually smaller as they go from one side to an opposite side of the second area; and
a plurality of third connection areas (734) connecting the plurality of third resistance areas, and
wherein the fourth strain gauge sensor includes:

a plurality of fourth resistance areas (742), lengths of which become gradually larger as they go from one side to an opposite side of the second area; and
a plurality of fourth connection areas (744) connecting the plurality of fourth resistance areas.

13. The display of claim 12, wherein at least any one of the third resistance area (732), the fourth resistance area (742), the third connection area (734), and the fourth connection area (744) is formed of the same material as that of the light shielding layer (1030) and is disposed on the same plane as that of the light shielding layer (1030).

14. The display of claim 12, wherein at least any one of the first resistance area (712), the second resistance area (722), the third resistance area (732), and the fourth resistance area (742)includes:

a first sub area (1016) overlapping an active layer of the driving thin film transistor; and
a second sub area (1018) not overlapping the active layer of the driving thin film transistor.

15. The display of claim 14, wherein a width of the second sub area (1018) in the second direction is smaller than that of the first sub area (1016).

**Patentansprüche**

1. Anzeige, umfassend:

einen ersten Bereich (A1), der ein aktiver Bereich ist;
einen zweiten Bereich (A2), der parallel zu dem ersten Bereich (A1) angeordnet ist und von dem ersten Bereich (A1) aus erweiterbar ist;
einen ersten Dehnungsmessstreifensensor (410, 710, 1010, 1110), der in dem zweiten Bereich (A2) angeordnet ist und in einer ersten Richtung, die eine Erweiterungsrichtung des zweiten Bereichs (A2) ist, zickzackförmig ausgebildet ist; und
einen zweiten Dehnungsmessstreifensensor (420, 720, 1020, 1120), der so angeordnet ist, dass er von dem ersten Dehnungsmessstreifensensor (410) in dem zweiten Bereich (A2) beabstandet ist und in der ersten Richtung zickzackförmig ausgebildet ist,
wobei der erste Dehnungsmessstreifensensor (410, 710, 1010, 1110) Folgendes beinhaltet:

eine Vielzahl von ersten Widerstandsbereichen (412, 712, 1012), deren Längen allmählich kleiner werden, wenn sie von einer Seite zu einer gegenüberliegenden Seite des zweiten Bereichs (A2) entlang einer zweiten Richtung gehen, die sich von der ersten Richtung unterscheidet; und
eine Vielzahl von ersten Verbindungsbereichen (414, 714, 1014), die die Vielzahl von ersten Widerstandsbereichen (412, 712, 1012) verbindet, und
wobei der zweite Dehnungsmessstreifensensor (420, 720, 1020, 1120) Folgendes beinhaltet:

eine Vielzahl von zweiten Widerstandsbereichen (422, 722, 1022), deren Längen allmählich größer werden, wenn sie von einer Seite zu einer gegenüberliegenden Seite des zweiten Bereichs (A2) gehen; und
eine Vielzahl von zweiten Verbindungsbereichen (424, 724, 1024), die die Vielzahl von zweiten Widerstandsbereichen (422, 722, 1022) verbindet.

2. Anzeige nach Anspruch 1, ferner umfassend:

eine leitfähige Schicht, die auf einem Substrat des ersten Bereichs (A1) angeordnet ist,
wobei mindestens einer von dem ersten Widerstandsbereich (412, 712, 1012), dem zweiten Widerstandsbereich (422, 722, 1022), dem ersten Verbindungsbereich (414, 714, 1014) und dem zweiten Verbindungsbereich (424, 724, 1024) aus dem gleichen Material wie das der leitfähigen Schicht gebildet ist und auf der gleichen Ebene wie die der leitfähigen Schicht angeordnet ist.

3. Anzeige nach Anspruch 1, ferner umfassend:

eine Lichtabschirmungsschicht (1030), die auf einem Substrat des ersten Bereichs (A1) angeordnet ist, wobei mindestens einer von dem ersten Widerstandsbereich (1012), dem zweiten Widerstandsbereich (1022), dem ersten Verbindungsbereich (1014) und dem zweiten Verbindungsbereich (1024) aus dem gleichen Material wie das der Lichtabschirmungsschicht gebildet ist und auf der gleichen Ebene wie die der Lichtabschirmungsschicht (1030) angeordnet ist.

4. Anzeige nach Anspruch 3, ferner umfassend:

einen Treibertransistor (T1), der die Lichtabschirmungsschicht (1030) überlappt; und ein lichtemittierendes Element, das mit dem Treibertransistor verbunden ist.

5. Anzeige nach Anspruch 4, wobei eine an die Lichtabschirmungsschicht (1030) angelegte Hochpotentialspannung dem ersten Dehnungsmessstreifensensor (410, 710, 1010) zugeführt wird, und wobei eine an einen Kathodenanschluss des lichtemittierenden Elements angelegte Niedrigpotentialspannung dem zweiten Dehnungsmessstreifensensor (420, 720, 1020) zugeführt wird.

6. Anzeige nach Anspruch 4, wobei mindestens einer von dem ersten Widerstandsbereich (1012) und dem zweiten Widerstandsbereich (1022) Folgendes beinhaltet:

einen ersten Teilbereich (1016), der eine aktive Schicht des Treiber-Dünnschichttransistors überlappt; und einen zweiten Teilbereich (1018), der die aktive Schicht des Treiber-Dünnschichttransistors nicht überlappt.

7. Anzeige nach Anspruch 1, wobei eine Dehnung des ersten Dehnungsmessstreifensensors (410, 710, 1010) abnimmt und eine Dehnung des zweiten Dehnungsmessstreifensensors (420, 720, 1020) zunimmt, wenn der zweite Bereich (A2) erweitert wird.

8. Anzeige nach Anspruch 4, ferner umfassend:

einen dritten Dehnungsmessstreifensensor (730, 1130), der von dem zweiten Dehnungsmessstreifensensor (720, 1120) in der zweiten Richtung beabstandet ist und die gleiche Form wie die des ersten Dehnungsmessstreifensensors (710, 1110) aufweist; und einen vierten Dehnungsmessstreifensensor (740, 1140), der von dem dritten Dehnungsmessstreifensensor (730, 1130) in der ersten Richtung beabstandet ist und die gleiche Form wie die des zweiten Dehnungsmessstreifensensors (720, 1120) aufweist.

9. Anzeige nach Anspruch 8, wobei eine an die Lichtabschirmungsschicht (1030) angelegte Hochpotentialspannung mindestens einem von dem ersten Dehnungsmessstreifensensor (710, 1110) und dem vierten Dehnungsmessstreifensensor (740, 1140) zugeführt wird, und wobei eine an einen Kathodenanschluss des lichtemittierenden Elements angelegte Niedrigpotentialspannung mindestens einem von dem zweiten Dehnungsmessstreifensensor (720, 1120) und dem dritten Dehnungsmessstreifensensor (730, 1130) zugeführt wird.

10. Anzeige nach Anspruch 8, wobei der erste Dehnungsmessstreifensensor (710, 1110), der zweite Dehnungsmessstreifensensor (720, 1120), der dritte Dehnungsmessstreifensensor (730, 1130) und der vierte Dehnungsmessstreifensensor (740, 1140) wiederholt mindestens einmal in mindestens einer von der ersten Richtung und der zweiten Richtung angeordnet sind.

11. Anzeige nach Anspruch 8, wobei Dehnungen des ersten Dehnungsmessstreifensensors (710, 1110) und des dritten Dehnungsmessstreifensensors (730, 1130) abnehmen und Dehnungen des zweiten Dehnungsmessstreifensensors (720, 1120) und des vierten Dehnungsmessstreifensensors (740, 1140) zunehmen, wenn eine Ausdehnung des zweiten Bereichs, der einer Außenseite ausgesetzt ist, zunimmt.

12. Anzeige nach Anspruch 8, wobei der dritte Dehnungsmessstreifensensor (730, 1130) Folgendes beinhaltet:

eine Vielzahl von dritten Widerstandsbereichen (732) s, deren Längen allmählich kleiner werden, wenn sie von einer Seite zu einer gegenüberliegenden Seite des zweiten Bereichs gehen; und

eine Vielzahl von dritten Verbindungsbereichen (734), die die Vielzahl von dritten Widerstandsbereichen verbindet, und

wobei der vierte Dehnungsmessstreifensensor Folgendes beinhaltet:

eine Vielzahl von vierten Widerstandsbereichen (742), deren Längen allmählich größer werden, wenn sie von einer Seite zu einer gegenüberliegenden Seite des zweiten Bereichs gehen; und

eine Vielzahl von vierten Verbindungsbereichen (744), die die Vielzahl von vierten Widerstandsbereichen verbindet.

13. Anzeige nach Anspruch 12, wobei mindestens einer von dem dritten Widerstandsbereich (732), dem vierten Widerstandsbereich (742), dem dritten Verbindungsbereich (734) und dem vierten Verbindungsbereich (744) aus dem gleichen Material wie das der Lichtabschirmungsschicht (1030) gebildet ist und auf der gleichen Ebene wie die der Lichtabschirmungsschicht (1030) angeordnet ist.

14. Anzeige nach Anspruch 12, wobei mindestens einer von dem ersten Widerstandsbereich (712), dem zweiten Widerstandsbereich (722), dem dritten Widerstandsbereich (732) und dem vierten Widerstandsbereich (742) Folgendes beinhaltet:

einen ersten Teilbereich (1016), der eine aktive Schicht des Treiber-Dünnschichttransistors überlappt; und

einen zweiten Teilbereich (1018), der die aktive Schicht des Treiber-Dünnschichttransistors nicht überlappt.

15. Anzeige nach Anspruch 14, wobei eine Breite des zweiten Teilbereichs (1018) in der zweiten Richtung kleiner als die des ersten Teilbereichs (1016) ist.

**Revendications**

1. Affichage comprenant :

une première zone (A1) qui est une zone active ;

une seconde zone (A2) disposée parallèlement à la première zone (A1) et étant extensible à partir de la première zone (A1) ;

un premier capteur à jauge de contrainte (410, 710, 1010, 1110) disposé dans la seconde zone (A2), et formé en forme de zigzag dans une première direction qui est une direction d'expansion de la seconde zone (A2) ; et

un deuxième capteur à jauge de contrainte (420, 720, 1020, 1120) disposé pour être espacé du premier capteur à jauge de contrainte (410) dans la seconde zone (A2), et formé en zigzag dans la première direction,

dans lequel le premier capteur à jauge de contrainte (410, 710, 1010, 1110) comprend :

une pluralité de premières zones de résistance (412, 712, 1012), dont les longueurs diminuent progressivement à mesure qu'elles vont d'un côté à un côté opposé de la seconde zone (A2) le long d'une seconde direction qui est différente de la première direction ; et

une pluralité de premières zones de connexion (414, 714, 1014) reliant la pluralité de premières zones de résistance (412, 712, 1012), et

dans lequel le deuxième capteur à jauge de contrainte (420, 720, 1020, 1120) comprend :

une pluralité de deuxièmes zones de résistance (422, 722, 1022), dont les longueurs augmentent progressivement à mesure qu'elles vont d'un côté à un côté opposé de la seconde zone (A2) ; et

une pluralité de deuxièmes zones de connexion (424, 724, 1024) connectant la pluralité de deuxièmes zones de résistance (422, 722, 1022).

2. Affichage selon la revendication 1, comprenant en outre :

une couche conductrice disposée sur un substrat de la première zone (A1),

dans lequel au moins l'une de la première zone de résistance (412, 712, 1012), de la deuxième zone de résistance (422, 722, 1022), de la première zone de connexion (414, 714, 1014) et de la deuxième zone de connexion (424, 724, 1024) est formée du même matériau que celui de la couche conductrice et est disposée sur le même plan que celui de la couche conductrice.

**3.** Affichage selon la revendication 1, comprenant en outre :

une couche de protection contre la lumière (1030) disposée sur un substrat de la première zone (A1),
dans lequel au moins l'une quelconque de la première zone de résistance (1012), de la deuxième zone de résistance (1022), de la première zone de connexion (1014) et de la deuxième zone de connexion (1024) est formée du même matériau que celui de la couche de protection contre la lumière et est disposée sur le même plan que celui de la couche de protection contre la lumière (1030).

**4.** Affichage selon la revendication 3, comprenant en outre :

un transistor de commande (T1) chevauchant la couche de protection contre la lumière (1030) ; et
un élément electroluminescent connecté au transistor de commande.

**5.** Affichage selon la revendication 4, dans lequel une tension à potentiel élevé appliquée à la couche de protection contre la lumière (1030) est fournie au premier capteur à jauge de contrainte (410, 710, 1010), et
dans lequel une tension à faible potentiel appliquée à une borne de cathode de l'élément electroluminescent est fournie au deuxième capteur à jauge de contrainte (420, 720, 1020).

**6.** Affichage selon la revendication 4, dans lequel au moins l'une quelconque de la première zone de résistance (1012) et de la deuxième zone de résistance (1022) comprend :

une première sous-zone (1016) chevauchant une couche active du transistor à couches minces de commande ; et
une seconde sous-zone (1018) ne chevauchant pas la couche active du transistor à couches minces de commande.

**7.** Affichage selon la revendication 1, dans lequel une contrainte du premier capteur à jauge de contrainte (410, 710, 1010) diminue et une contrainte du deuxième capteur à jauge de contrainte (420, 720, 1020) augmente à mesure que la seconde zone (A2) est étendue.

**8.** Affichage selon la revendication 4, comprenant en outre :

un troisième capteur à jauge de contrainte (730, 1130) espacé du deuxième capteur à jauge de contrainte (720, 1120) dans la seconde direction, et ayant la même forme que celle du premier capteur à jauge de contrainte (710, 1110) ; et
un quatrième capteur à jauge de contrainte (740, 1140) espacé du troisième capteur à jauge de contrainte (730, 1130) dans la première direction, et ayant la même forme que celle du deuxième capteur à jauge de contrainte (720, 1120).

**9.** Affichage selon la revendication 8, dans lequel une tension à potentiel élevé appliquée à la couche de protection contre la lumière (1030) est fournie à au moins l'un quelconque du premier capteur à jauge de contrainte (710, 1110) et du quatrième capteur à jauge de contrainte (740, 1140), et
dans lequel une tension à faible potentiel appliquée à une borne de cathode de l'élément electroluminescent est fournie à au moins l'un quelconque du deuxième capteur à jauge de contrainte (720, 1120) et du troisième capteur à jauge de contrainte (730, 1130).

**10.** Affichage selon la revendication 8, dans lequel le premier capteur à jauge de contrainte (710, 1110), le deuxième capteur à jauge de contrainte (720, 1120), le troisième capteur à jauge de contrainte (730, 1130) et le quatrième capteur à jauge de contrainte (740, 1140) sont disposés de manière répétée au moins une fois dans au moins l'une quelconque de la première direction et de la seconde direction.

**11.** Affichage selon la revendication 8, dans lequel les contraintes du premier capteur à jauge de contrainte (710, 1110) et du troisième capteur à jauge de contrainte (730, 1130) diminuent et les contraintes du deuxième capteur à jauge de contrainte (720, 1120) et du quatrième capteur à jauge de contrainte (740, 1140) augmentent à mesure que l'étendue de la deuxième zone exposée à un extérieur augmente.

**12.** Affichage selon la revendication 8, dans lequel le troisième capteur à jauge de contrainte (730, 1130) comprend :

une pluralité de troisièmes zones de résistance (732), dont les longueurs diminuent progressivement à mesure qu'elles vont d'un côté à un côté opposé de la seconde zone ; et
une pluralité de troisièmes zones de connexion (734) connectant la pluralité de troisièmes zones de résistance, et dans lequel le quatrième capteur à jauge de contrainte comprend :

une pluralité de quatrièmes zones de résistance (742), dont les longueurs augmentent progressivement à mesure qu'elles vont d'un côté à un côté opposé de la deuxième zone ; et
une pluralité de quatrièmes zones de connexion (744) connectant la pluralité de quatrièmes zones de résistance.

13. Affichage selon la revendication 12, dans lequel au moins l'une quelconque de la troisième zone de résistance (732), de la quatrième zone de résistance (742), de la troisième zone de connexion (734) et de la quatrième zone de connexion (744) est formée du même matériau que celui de la couche de protection contre la lumière (1030) et est disposée sur le même plan que celui de la couche de protection contre la lumière (1030).

14. Affichage selon la revendication 12, dans lequel au moins l'une quelconque de la première zone de résistance (712), de la deuxième zone de résistance (722), de la troisième zone de résistance (732) et de la quatrième zone de résistance (742) comprend :

une première sous-zone (1016) chevauchant une couche active du transistor à couches minces de commande ; et
une seconde sous-zone (1018) ne chevauchant pas la couche active du transistor à couches minces de commande.

15. Affichage selon la revendication 14, dans lequel une largeur de la seconde sous-zone (1018) dans la seconde direction est inférieure à celle de la première sous-zone (1016).

FIG.1

EP 4 290 578 B1

FIG.2

EP 4 290 578 B1

$$R_{210} = \sum_{n=1}^{N} R_n$$

FIG.3

FIG.4A

FIG.4B

FIG.5A

FIG.5B

FIG.6

710
714  712

RA(S1)          RA(S2)  710

SG1

714  712    724  722
710         720

730
734  732

SG3

730
734  732    744  742
730         740

720

SG2

730

A2

SG4

Y
X

740

Slide out

FIG.7

FIG.8

FIG.9A

FIG.9B

FIG. 10A

FIG.10B

T1  T1

1056  1056
1054  1054

1057
1055
1053
1052

1051

1018  1016  1018  1016  1018

FIG.10C

F I G . 11A

FIG.11B

FIG.12

FIG.13

FIG.14

FIG.15

EP 4 290 578 B1

1650

1620 1610

1638
1631
1637
1631
1636
1631
1635
1631
1634
1631
1632

1630

1660

Z

X

F I G. 16

FIG.17

FIG.18

FIG.19

FIG.20

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 2019041830 A1

- US 2017123558 A1